# EUROPÄISCHE PATENTSCHRIFT

(11) **EP 3 864 694 B1**
(45) Veröffentlichungstag und Bekanntmachung des Hinweises auf die Patenterteilung: **09.04.2025**
(21) Anmeldenummer: 19831724.0
(22) Anmeldetag: 20.12.2019
(51) Int. Cl.: H01L 23/373, H01L 23/15, H01L 23/31, H01L 23/433, H01L 25/16, H01L 23/00, H01L 23/473, H01L 25/07

(54) **VERFAHREN ZUR HERSTELLUNG EINES ELEKTRONIKMODULS**
METHOD OF MANUFACTURING AN ELECTRONIC MODULE
MÉTHODE DE FABRICATION D'UN MODULE ÉLECTRONIQUE

(30) Priorität: 21.12.2018 DE 102018133479
(43) Veröffentlichungstag der Anmeldung: 18.08.2021
(73) Patentinhaber: Rogers Germany GmbH, 92676 Eschenbach (DE)
(72) Erfinder: GIL, Vitalij, 91217 Hersbruck (DE)
(74) Vertreter: Müller Schupfner & Partner Patent- und Rechtsanwaltspartnerschaft mbB (Muc)
(86) Internationale Anmeldenummer: PCT/EP2019/086617
(87) Internationale Veröffentlichungsnummer: WO 2020/127932

(56) Entgegenhaltungen:
- US-A1- 2010 065 962
- US-A1- 2010 133 684
- US-A1- 2012 056 312
- US-A1- 2016 365 333
- US-A1- 2017 200 666
- US-A1- 2018 053 745
- US-A1- 2018 174 946

## Beschreibung

Die vorliegende Erfindung betrifft ein Verfahren zur Herstellung eines Elektronikmoduls.

Elektronikmodule sind aus dem Stand der Technik, beispielsweise als Leistungselektronikmodule, hinlänglich bekannt. Solche Elektronikmodule nutzen typischerweise schaltbare Elektronikbauteile, die auf einem gemeinsamen Trägersubstrat über Leiterbahnen miteinander verschaltet sind. Wesentliche Bestandteile des Trägersubstrats sind dabei eine Isolationsschicht, die beispielsweise im Falle eines Metall-Keramik-Substrats aus einem eine Keramik umfassenden Material gefertigt ist, und eine Metallisierungsschicht, die zur Bildung von Leiterbahnen vorzugsweise strukturiert und an einer Bauteilseite des Trägersubstrats ausgebildet ist.

Solche Elektronikmodule werden typischerweise für eine hohe Lebensdauer und hohe Betriebssicherheit so ausgelegt, dass möglichst thermisch induzierte mechanische Spannungen im Elektronikmodul vermieden werden und an der Bauteilseite entstehende Wärme möglichst optimal abgeleitet werden kann, vorzugsweise mittels einer hierzu vorgesehenen Kühlstruktur. Dabei stellen die Spezifikationen neuer elektronischer Bauteile, wie z. B. WBG-Halbleiter (wide bandgap semiconductors), insbesondere Halbleiter aus Siliziumcarbid, Galliumnitrid und/oder Indiumgalliumnitrid, die Elektronikmodule genauso vor neue Herausforderung wie neuartige Einsatzgebiete, z. B. im Bereich der E-Mobilität.

Aus dem Stand der Technik sind beispielsweise die Druckschriften DE 10 2008 029 829 B4, DE 10 2009 042 399 A1, US 7 589 412 B2 und DE 10 2014 117 086 A1 bekannt, in denen elektrische Bauteile zur Ausbildung eines Elektronikmoduls auf einem Trägersubstrat angeordnet und in einer Verkapselung eingebettet sind. Ein weiteres Beispiel für ein Elektronikmodul ist das von Anlog Devices vertriebene Bauteil mit der Bezeichnung "LTM4636".

Aus der US 2017 200 666 A1 und der US 2012 0 056 312 A1 ist jeweils ein Elektronikmodul mit Verkapselung bekannt.

Insbesondere zeigt US 2017 200 666 A1 ein Verfahren zur Herstellung eines Elektronikmoduls, umfassend:
- Bereitstellen eines mit einem ersten elektronischen Bauteil bestückten Trägersubstrats,
- zumindest teilweise Verkapseln des bestückten Trägersubstrats mit einer Verkapselung,
- Realisieren einer zweiten Aussparung in der Verkapselung und
- Ausbilden einer Durchkontaktierung zum Bereitstellen einer elektrischen Verbindung zwischen einem zweiten elektronischen Bauteil an einer Außenseite der Verkapselung und einer metallischen Schicht.

Ausgehend von diesem Stand der Technik macht es sich die vorliegende Erfindung zur Aufgabe, ein Elektronikmodul bereitzustellen, das gegenüber denen aus dem Stand der Technik verbessert ist, insbesondere in Hinblick auf ein vereinfachtes Herstellungsverfahren.

Die Aufgabe wird erfindungsgemäß durch ein Verfahren zum Herstellen eines Elektronikmoduls gemäß Anspruch 1 gelöst. Bevorzugte Ausgestaltungen der Erfindung sind in den abhängigen Ansprüchen sowie der nachfolgenden Beschreibung, insbesondere im Zusammenhang mit den beiliegenden Figuren, angegeben. Erfindungsgemäß ist ein Verfahren zur Herstellung eines Elektronikmoduls vorgesehen, umfassend:
- Bereitstellen eines mit einem ersten elektronischen Bauteil bestückten Trägersubstrats, wobei das Trägersubstrat eine Primärschicht, eine Sekundärschicht und eine zwischen der Primärschicht und der Sekundärschicht angeordnete metallische Zwischenschicht, insbesondere als elektronischer Rückleiter, aufweist und, wobei die Primärschicht eine erste Aussparung aufweist,
- zumindest teilweise Verkapseln des bestückten Trägersubstrats mit einer Verkapselung,
- Realisieren einer zweiten Aussparung in der Verkapselung und
   Ausbilden einer Durchkontaktierung zum Bereitstellen einer elektrischen Verbindung zwischen einem zweiten elektronischen Bauteil an einer Außenseite der Verkapselung und der metallischen Zwischenschicht, wobei die erste Aussprung in der Primärschicht und die zweite Aussparung in der Verkapselung in einem Arbeitsschritt mit einem elektrisch leitfähigen Material gemeinsam bzw. gemeinschaftlich gefüllt und/oder miteinander elektrisch kontaktiert werden

Insbesondere kann in vorteilhafter Weise darauf verzichtet werden, dass das Trägersubstrat mit einer trägersubstrateigenen Durchkontaktierung bereitgestellt werden muss. Solche trägersubstrateigenen Durchkontaktierungen würden andernfalls im Fertigungsprozess des Trägersubstrats, d. h. während des Anbindens der Primärschicht an die Zwischenschicht, beispielsweise mit einem Hartlöt- bzw. AMB Verfahren realisiert. Solche durch Löten realisierten, trägersubstrateigenen Durchkontaktierungen beschränken eine Prozessreihenfolge in der Herstellung des Trägersubstrats und müssen über einen Dispensprozess hergestellt werden. Durch das erfindungsgemäße Verfahren lassen sich diese Probleme vermeiden, da auf die Ausbildung der trägersubstrateigenen Durchkontaktierungen verzichtet werden kann und stattdessen die erste Aussparung in der Primärschicht während des Füllens der zweiten Aussparung in der Verkapselung mitgefüllt wird. Zudem ist es möglich, auf das für das Löten erforderliche spezielle Material zu verzichten. Dadurch ist man in der Materialwahl für die Durchkontaktierung flexibler, wodurch Kosten und Eigenschaften der Durchkontaktierung optimiert werden können. Ferner ist es in vorteilhafter Weise möglich, den Herstellungsprozess der Durchkontaktierung, die von der Außenseite bis zur Zwischenschicht verläuft, besser zu kontrollieren, was sich positiv auf die Qualität der gefertigten Durchkontaktierungen auswirkt und die Anzahl der Ausfälle von Elektronikmodulen bei der Bildung von Durchkontaktierungen reduziert.

Es ist weiterhin vorstellbar, dass sich die Durchkontaktierungen in einem DCB-Verfahren herstellen lassen, insbesondere unter Verwendung von Kupferkügelchen oder Pasten. Beispielsweise lassen sich mit dem DCB-Verfahren Freiräume bzw. Aussparung realisieren, die später mit einer Paste oder Vergleichbaren verfüllt werden können, um so ein Durchkontaktierung zu bilden.

Durch das gemeinschaftliche Füllen der ersten Aussparung und der zweiten Aussparungen entsteht in einer vorteilhaften Variante der Erfindung eine einstückige, insbesondere materialeinheitliche Durchkontaktierung, die von der Außenseite der Verkapselung bis zur Zwischenschicht verläuft. Dabei umfasst die Durchkontaktierung einen Teilabschnitt in der Verkapselung und einen Teilabschnitt, der durch die Primärschicht und die erste Metallisierungsschicht verläuft. Mittels der Durchkontaktierung ist es in vorteilhafter Weise möglich, von der Außenseite der Verkapselung eine direkte elektrische Verbindung zu der metallischen Zwischenschicht zwischen der Primärschicht und der Sekundärschicht zur realisieren. Dabei ist es vorgesehen, dass die Verkapselung das Trägersubstrat z. B. in Form eines Gussmaterials zumindest teilweise umgibt bzw. das Trägersubstrat ist in der Verkapselung eingebettet.

Ferner ist bevorzugt ein Verfahren vorgesehen, bei dem die Primärschicht, die Zwischenschicht und die Sekundärschicht in einer Stapelrichtung übereinander angeordnet sind und die erste Aussparung und die zweite Aussparung in Stapelrichtung gesehen übereinander, jedenfalls teilweise fluchtend, angeordnet sind.

Erfindungsgemäß ist es vorgesehen, dass sich die zwischen der Primärschicht und der Sekundärschicht angeordnete metallische Zwischenschicht in einer parallel zur Haupterstreckungsebene verlaufenden Ebene über eine erste Fläche erstreckt und die Primärschicht und/oder die zweite Sekundärschicht über eine zweite Fläche, wobei ein Verhältnis der ersten Fläche zu der zweiten Fläche größer ist als 0,5, bevorzugt größer als 0,75 und besonders bevorzugt größer 0,9. Insbesondere ist es vorgesehen, dass das Verhältnis zwischen der ersten Fläche und der zweiten Fläche im Wesentlichen 1 ist, d. h. die metallische Zwischenschicht erstreckt sich vollflächig unterhalb der Primärschicht. Erfindungsgemäß ist es vorgesehen, dass die metallische Zwischenschicht die Primärschicht von der Sekundärschicht beabstandet. Erfindungsgemäß bilden die Primärschicht, die metallische Zwischenschicht und die Sekundärschicht eine Sandwichstruktur. Weiterhin ist es vorgesehen, dass Primärschicht das erste elektrisch Bauteil von der metallischen Zwischenschicht trennt, d. h. die Primärschicht ist zwischen dem ersten elektrischen Bauteil und der metallischen Zwischenschicht angeordnet.

Weiterhin ist es bevorzugt vorgesehen, dass die Primärschicht eine in Stapelrichtung bemessene Dicke aufweist, die größer als 100 µm, bevorzugt größer als 200 µm und besonders bevorzugt größer als 250 µm ist. Weiterhin ist es bevorzugt vorgesehen, dass die Primärschicht oder das Trägersubstrat silikonfrei ist, d. h. ein Anteil an Silikon am Trägersubstrat ist kleiner als 1 Gew.-%, bevorzugt kleiner als 0,5 Gew.-% und besonders bevorzugt kleiner als 0,1 Gew.-%. Ferner erstreckt sich die Primärschicht und/oder die Sekundärschicht bevorzugt in einer Ebene, d. h. die Primärschicht und/oder die Sekundärschicht bilden keine Täler oder Erhöhungen bzw. keine Wellen oder Vorsprünge aus. Beispielsweise verlaufen die Primärschicht und die Sekundärschicht parallel zueinander.

Weiterhin ist es vorstellbar, dass die metallische Zwischenschicht in Richtung der Haupterstreckungsebene gegenüber einem äußersten Rand der Primärschicht übersteht und mittels der Durchkontaktierung eine elektrisch leitenden Verbindung mit dem überstehenden, insbesondere seitlich bzw. lateral überstehende, Abschnitt der metallischen Zwischenschicht realisiert wird. In diesem Fall bildet der freigelassene Randbereich der Primärschicht die erste Aussparung. Dadurch lässt sich vergleichsweise einfach eine erste Aussparung realisieren. Es ist ferner vorstellbar, dass die metallische Zwischenlage in der Haupterstreckungsebene bündig mit der Primärschicht abschließt und die Durchkontaktierung die Primärschicht seitlich passiert und die metallische Zwischenschicht von der Seite kommend, d. h. parallel zur Haupterstreckungsebene, kontaktiert.

Ferner ist es bevorzugt vorgesehen, dass das Trägersubstrat eine erste Metallisierungsschicht aufweist, an der mindestens ein erstes elektronisches Bauteil angeordnet ist, wobei eine dritte Aussparung in der Verkapselung und eine weitere Durchkontaktierung zum elektrischen Verbinden einer zweiten Metallisierungsschicht an der Außenseite der Verkapselung mit der ersten Metallisierungsschicht und/oder des ersten elektronischen Bauteils realisiert werden, wobei die dritte Aussparung mit einem elektrisch leitenden Material gefüllt wird, insbesondere zeitgleich zum Füllen der ersten und zweiten Aussparung. Mit der weiteren Durchkontaktierung wird eine Möglichkeit zur unmittelbaren, d. h. nicht über die Zwischenschicht verlaufenden, elektrischen Verbindung zwischen dem ersten elektrischen Bauteil und dem zweiten elektrischen Bauteil, bereitgestellt. Dabei erstreckt sich die weitere Durchkontaktierung von der Außenseite, insbesondere von der als Anschluss für die zweiten elektronischen Bauteile dienenden zweiten Metallisierungsschicht, bis zum ersten elektronischen Bauteil und/oder zur ersten Metallisierungsschicht auf der Bauteilseite des Trägersubstrats. Infolgedessen entsteht nicht nur ein kompaktes Elektronikmodul, sondern es wird ein vergleichsweise geringer Abstand zwischen dem ersten elektronischen Bauteil auf der Bauteilseite einerseits und den zweiten elektronischen Bauteilen auf der Außenseite andererseits bereitgestellt. Insbesondere zeichnet sich die Erfindung durch die zweite Metallisierungsschicht aus, die ein unmittelbares Anbinden an der Außenseite der Verkapselung gestattet. Durch das zeitgleiche Ausbilden der Durchkontaktierung, die bis zur Zwischenschicht ragt, und der weiteren Durchkontaktierung, die bis zum ersten elektronischen Bauteil ragt, lässt sich in vorteilhafter Weise die Fertigungszeit optimieren.

Vorzugsweise ist es vorgesehen, dass ein senkrecht zur Haupterstreckungsebene bemessener Abstand zwischen der ersten Metallisierungsschicht und der zweiten Metallisierungsschicht geringer als 5 mm, bevorzugt geringer als 2,5 mm und besonders bevorzugt geringer als 1 mm bis hin zu weniger als 400 µm, beispielsweise in etwa 300 µm, ist, d. h. möglichst gering ist. Besonders bevorzugt ist es vorgesehen, dass der Abstand kleiner als 200 µm oder 100 µm ist. Es ist besonders bevorzugt vorstellbar, dass sich der Abstand auf einen Wert zwischen 100 und 200 µm bemisst. Entsprechend stellt sich in einer senkrecht zur Haupterstreckungsebene verlaufenden Richtung ein sehr kurzer Abstand zwischen dem ersten elektrischen Bauteil und dem weiteren zweiten elektrischen Bauteil ein.

Weiterhin ist es bevorzugt vorgesehen, dass die erste Metallisierungsschicht und die zweite Metallisierungsschicht so strukturiert sind, dass im montierten Zustand in einer parallel zur Haupterstreckungsebene verlaufenden Richtung das erste Bauteil und das zweite Bauteil um einen lateralen Abstand zueinander versetzt sind. Dadurch wird in vorteilhafter Weise vermieden, dass die Wärmeentwicklung des ersten und des zweiten Bauteils sich gegenseitig beeinflussen bzw. beeinträchtigen. Um eine wirkungsvolle Ansteuerung des ersten Bauteils durch das zweite Bauteil zu gewährleisten, ist es vorzugsweise vorgesehen, dass der laterale Abstand kleiner ist als 35 mm, bevorzugt kleiner als 15 mm und besonders bevorzugt kleiner als 5 mm.

Unter einem "Einbetten" bzw. "eingebettet sein" ist insbesondere ein unmittelbares Angrenzen der Verkapselung an einer Außenseite des Trägersubstrats zu verstehen, d. h. die Verkapselung liegt zumindest bereichsweise unmittelbar flächig am Trägersubstrat an und es wird kein lichter Bereich bzw. Hohlraum zwischen dem mit dem elektronischen Bauteil bestückten Trägersubstrat und der Verkapselung ausgebildet. Dabei muss das Trägersubstrat nicht an allen Seiten von der Verkapselung ummantelt bzw. umgeben sein. Ferner ist es vorgesehen, dass die Verkapselung massiv ist, d.h. frei von Hohlräumen ist.

Weiterhin ist es vorzugsweise vorgesehen, dass die Durchkontaktierung und/oder die weitere Durchkontaktierung jeweils einen in einer parallel zur Haupterstreckungsebene bemessenen Querschnitt von weniger als 5 mm² aufweist, bevorzugt weniger als 1,5 mm² und besonders bevorzugt weniger als 0,5 mm², insbesondere wenn die weitere Durchkontaktierung unmittelbar an das erste Bauteil, insbesondere an eine Oberseite des ersten Bauteils, angebunden ist. Sollte die weitere Durchkontaktierung an der ersten Metallisierungsschicht angebunden sein, ist der Querschnitt vorzugsweise kleiner als 3,5 mm², bevorzugt kleiner als 2,5 mm² und besonders bevorzugt kleiner als 1,5 mm². Da sich der Querschnitt in Stapelrichtung gesehen aus fertigungstechnischen Gründen verändert, insbesondere in Richtung zum Substrat hin verjüngen kann, ist als Querschnitt vorzugsweise dessen Durchschnittsquerschnitt entlang seiner Erstreckung in Stapelrichtung zu verstehen.

Weiterhin ist es vorgesehen, dass die Durchkontaktierung und/oder die weitere Durchkontaktierung bündig mit der Außenseite der Verkapselung abschließt. Der bündig und insbesondere unmittelbar an die Durchkontaktierung bzw. weitere Durchkontaktierung anschließende Teil der zweiten Metallisierungsschicht weist weiterhin eine parallel zur Haupterstreckungsebene bemessene Kontaktfläche auf. Ein Verhältnis zwischen einem parallel zur Haupterstreckungsebene bemessenen Querschnitt der Durchkontaktierung zur Kontaktfläche des sich an die Durchkontaktierung anschließenden Teils der zweiten Metallisierungsschicht nimmt vorzugsweise einen Wert kleiner als 0,25, bevorzugt kleiner als 0,15 und besonders bevorzugt kleiner als 0,1 an. Mit anderen Worten: die Durchkontaktierung ist vergleichsweise schmal ausgestaltet. Weiterhin ist es vorstellbar, dass mehrere Durchkontaktierungen bzw. weitere Durchkontaktierungen mit einem gemeinsamen elektronischen Bauteil verbunden sind und der aufsummierte Querschnitt aller Durchkontaktierungen kleiner ist als die Kontaktfläche der zweiten Metallisierungsschicht.

Die weiteren Durchkontaktierungen zeichnen sich weiterhin bevorzugt dadurch aus, dass die weiteren Durchkontaktierungen in Stapelrichtung gesehen oberhalb der ersten Metallisierungsschicht bzw. zwischen den ersten elektronischen und den zweiten elektronischen Bauteilen angeordnet sind. Dabei ist es vorstellbar, dass ein erster Anteil aller weiteren Durchkontaktierungen die ersten Bauteile unmittelbar kontaktiert und ein zweiter Anteil aller weiteren Durchkontaktierungen die erste Metallisierungsschicht unmittelbar kontaktiert. Vorzugsweise ist der zweite Teil größer als der erste Teil oder der erste Teil ist größer als der zweite Teil.

Die Kontaktierung des ersten Bauteils und des zweiten Bauteils über die weitere Durchkontaktierung kann direkt oder indirekt bzw. mittelbar erfolgen. Beispielsweise kann das erste Bauteil selbst in einem Vorverbund integriert sein oder die weitere Durchkontaktierung kontaktiert die erste Metallisierungsschicht, um eine elektrische Verbindung zwischen dem ersten Bauteil und dem zweiten Bauteil zu realisieren.

Vorzugsweise bleibt zumindest eine Außenseite des Trägersubstrats frei von der Verkapselung. Insbesondere ist es vorgesehen, dass zumindest die Bauteilseite des Trägersubstrats vollständig verkapselt, d. h. bedeckt bzw. umschlossen ist von der Verkapselung. Weiterhin ist es vorstellbar, dass eine Außenseite bzw. Außenfläche oder Außenumfang zu mehr als 40 %, bevorzugt mehr als 50 % und besonders bevorzugt mehr als 60 % von der Verkapselung bedeckt ist. Durch die unmittelbare Anbindung an das Trägersubstrat bzw. das Einbetten des Trägersubstrats in der Verkapselung wird in vorteilhafter Weise auch die Stabilität des Elektronikmoduls verbessert und es kann auf zusätzliche Maßnahmen zur Stabilisierung, z. B. zwischen der Verkapselung und dem Trägersubstrats, verzichtet werden. Denkbar ist auch, dass zwischen den ersten elektronischen Bauteilen und der Verkapselung eine Schutzschicht vorgesehen ist, die die ersten elektronischen Bauteile verkleidet bzw. schützt und durch die die Durchkontaktierung und/oder weitere Durchkontaktierungen verlaufen.

Als erste elektronische Bauteile sind vorzugsweise schaltbare Bauteile bzw. aktive Bauteile zu verstehen. Vorzugsweise handelt es sich bei zumindest einem ersten elektrischen Bauteil um eines mit einem WBG-Halbleiter (wide bandgap semiconductors), wie z. B. einem Halbleiter aus Siliziumcarbid, Galliumnitrid und/oder Indiumgalliumnitrid, oder Siliziumhalbleiterelement. Beispiele für ein elektronisches Bauteil sind MOSFETs ("metal-oxide-semiconductor field-effect transistor") oder IGBTs ("insulated-gate bipolar transistor"). Die ersten elektronischen Bauteile können auch als Vorverbund bzw. "Prepackaging" zusammengefasst sein. In einem solchen Vorverbund sind ein oder mehrere erste elektronische Bauteile beispielsweise auf einer Leiterplatte angeordnet und in einer Matrix eingebettet.

Ein Beispiel für ein Vorverbund findet sich in der Druckschrift DE 10 2014 117 086 A1 als Umverteilungsstruktur, bei der ein elektrisches Bauteil in eine dielektrische Matrix integriert ist. Auf den Offenbarungsgehalt der DE 10 2014 117 086 A1 bezüglich des Vorverbunds bzw. der Umverteilungsstruktur wird hiermit explizit Bezug genommen. Weitere Beispiele für einen Vorverbund auf die explizit Bezug genommen wird, sind in den Artikeln "Development of Embedded Power Electronics Modules für Automotive Applications" von L. Boettcher et al. und "Embedding of Power Semiconductors for Innovative Packages and Modules" von L. Boettcher et al. zu finden.

Als zweite elektronische Bauteile und/oder Kontaktelemente sind vorzugsweise
- Treiber - bzw. Steuerelemente, insbesondere "Gate treiber", und/oder
- Anschlussvorrichtungen, die z. B. als Lastanschluss für ein Eingangssignal oder zur Energieversorgung dienen, und/oder
- Kondensatoren, beispielsweise Zwischenkondensatoren
vorgesehen und werden insbesondere unmittelbar auf die als Anschluss dienende zweite Metallisierungsschicht kontaktiert, z. B. aufgelötet bzw. aufgesintert. Unter einem "Gate-Treiber", z. B. einem MOSFET-Treiber, IGBT-Treiber oder Halbbrücken-Treiber, versteht man insbesondere eine diskrete oder integrierte elektronische Schaltung, welche Leistungsschalter, wie beispielsweise MOSFETs oder IGBTs, ansteuert. Im Falle von Steuerelementen als zweite elektronische Bauteile, lassen sich so die ersten elektronischen Bauteile auf der Bauteilseite verbessert ansteuern, da in vorteilhafter Weise auf lange Übertragungswege für das Ansteuersignal vom Steuerelement an der Außenseite zum anzusteuernden ersten elektronischen Bauteil verzichtet werden kann. Ein weiterer Vorteil, der sich aus den vergleichsweise kurzen Leiterbahnen ergibt, ist eine Reduktion von parasitären Induktivitäten, mit denen andernfalls zu rechnen wäre, wenn man keine Verkapselung und keine Durchkontaktierung für die elektrische Verbindung zwischen der Außenseite der Verkapselung und der Bauteilseite des Trägersubstrats vorgesehen wäre.

Als Durchkontaktierung bzw. als Via und/oder als weitere Durchkontaktierung ist ein elektrischer Leitungspfad zu verstehen, der die Verkapselung durchgreift bzw. zwei gegenüberliegende bzw. aneinander angrenzende Seiten der Verkapselung miteinander elektrisch leitend verbindet. Dabei kann die Durchkontaktierung bzw. weitere Durchkontaktierung aus demselben Metall bzw. Material gefertigt sein wie die erste Metallisierungsschicht, die zweite Metallisierungsschicht und/oder die metallische Zwischenschicht oder sich davon unterscheiden. Ferner ist es denkbar, dass die Durchkontaktierung und/oder weitere Durchkontaktierung vollständig oder nur teilweise mit einem leitenden Material gefüllt ist. Weiterhin verläuft die Durchkontaktierung vorzugsweise geradlinig. Dabei kann die Durchkontaktierung parallel oder schräg zu einer senkrecht zur Haupterstreckungsebene des Trägersubstrats erstreckenden Richtung verlaufen. Über die weitere Durchkontaktierung lässt sich zudem eine Kontaktierung des ersten elektronischen Bauteils über eine dem Trägersubstrat abgewandte Seite bzw. über eine der Außenseite des Verkapselung zugewandten Seite realisieren, d. h. elektrische Anschlüsse lassen sich auch nach "oben" aus der Verkapselung herausführen. Im Falle eines Vorverbunds bzw. "Prepacking" ist es in vorteilhafter Weise möglich, an einer im verbauten Zustand der Außenseite zugewandten Seite des Vorverbunds eine vorverbundseitige Kontaktierungsfläche zu realisieren. Dabei bietet es sich in vorteilhafter Weise an, die vorverbundseitige Kontaktierungsfläche zu vergrößern, um eine Anbindung an die weitere Durchgangskontaktierung in der Verkapselung zu erleichtern. Beispielsweise nimmt ein Verhältnis zwischen einem parallel zur Haupterstreckungsebene gemessenen Durchmesser der Durchkontaktierung bzw. weiteren Durchkontaktierung zu der parallel zur Haupterstreckungsebene gemessenen vorverbundseitigen Kontaktierungsfläche einen Wert zwischen 0,1 und 1, bevorzugt zwischen 0,15 und 0,8 und bevorzugt zwischen 0,3 und 0,6 an.

Vorzugsweise ist es vorgesehen, dass die ersten elektronischen Bauteile im Elektronikmodul auf einer der Außenseite der Verkapselung, insbesondere der zweiten Metallisierungsschicht zugewandten Seite, einen Kontakt aufweisen und über diesem Kontakt mit der weiteren Durchkontaktierung verbunden sind.

Insbesondere ist es vorgesehen, dass die Verkapselung ein Gussteil ist und vorzugsweise aus einem Kunststoff mittels Gießen, z. B. Spritzgießen, gefertigt ist. Dabei wirkt die Verkapselung im zusammengesetzten Elektronikmodul form-, kraft- und/oder stoffschlüssig mit dem Trägersubstrat zusammen. Beispielsweise umfasst die Verkapselung eine Hinterschneidung bzw. einen nasenartigen Vorsprung, über den die Verkapselung mit dem bestückten Trägersubstrat formschlüssig zusammenwirken kann. Insbesondere lässt sich die Verkapselung mit dem Trägersubstrat verclipsen bzw. ist mit dem Trägersubstrat, bevorzugt an dessen der Bauteilseite gegenüberliegender Seite, die oft zu Kühlzwecken genutzt wird, verclipst. Geeignete Gussmaterialien, auch Moldmasse genannt, sind Gießharze wie z. B. synthetische Duroplaste. Bevorzugt ist die Verkapselung aus einer Epoxid-Vergusskomponente als Verkapselungsmaterial gefertigt. Dabei hat die Vergusskomponente bevorzugt eine vergleichsweise hohe Glasübergangstemperatur, beispielswiese über 200 °C, eine Biegefestigkeit zwischen 10 und 15 kg/mm² und ist insbesondere aushärtbar. Beispielsweise handelt es bei dem Material um Hysol^{®} MG 15F-MOD2. Weiterhin ist es bevorzugt vorgesehen, dass dem Verkapselungsmaterial ein Füllmaterial, beispielsweise umfassend SiO₂ und/oder ein Aluminiumoxid, beigefügt ist.

Als Materialien für die erste Metallisierungsschicht bzw. die zweite Metallisierungsschicht und/oder die metallische Zwischenschicht sind Kupfer, Aluminium, Molybdän und/oder deren Legierungen, sowie Laminate wie CuW, CuMo, CuAl, AlCu und/oder CuCu, insbesondere eine Kupfersandwichstruktur mit einer ersten Kupferschicht und einer zweiten Kupferschicht, wobei sich eine Korngröße in der ersten Kupferschicht von einer zweiten Kupferschicht unterscheidet, vorstellbar. Weiterhin ist es bevorzugt vorgesehen, dass die erste Metallisierungsschicht und/oder die zweite Metallisierungsschicht oberflächenmodifiziert sind. Als Oberflächenmodifikation ist beispielsweise eine Versiegelung mit einem Edelmetall, insbesondere Silber und/oder Gold, oder ENIG ("Electroless nickel immersion gold") oder ein Kantenverguss an der ersten bzw. zweiten Metallisierungsschicht zur Unterdrückung einer Rissbildung bzw. -weitung denkbar.

Vorzugsweise ist die zweite Metallisierungsschicht strukturiert und/oder die ersten elektronischen Bauteile sind über die Durchkontaktierung und/oder die weitere Durchkontaktierung durch mehrere zweite elektronische Bauteile ansteuerbar.

Gemäß einer bevorzugten Ausführungsform der vorliegenden Erfindung ist das Trägersubstrat ein Metall-Keramik-Substrat, wobei das Metall-Keramik-Substrat an seiner Bauteilseite eine strukturierte erste Metallisierungsschicht aufweist, wobei das Metall-Keramik-Substrat vorzugsweise mehrlagig ausgestaltet ist. Wesentliche Bestandteile der Metall-Keramik-Substrate sind eine Primärschicht, die aus einer Keramik gefertigt ist, und die an die Primärschicht angebundene Metallisierungsschicht. Wegen ihren vergleichsweise hohen Isolationsfestigkeiten haben sich aus Keramik gefertigte Primärschichten als besonders vorteilhaft erwiesen. Durch eine Strukturierung der ersten Metallisierungsschicht können sodann Leiterbahnen und/oder Anschlussflächen für die ersten elektrischen Bauteile realisiert werden. Insbesondere ist das Metall-Keramik-Substrat drei- oder fünflagig ausgestaltet. Durch die mehrlagige Ausgestaltung ist es in vorteilhafter Weise möglich vergleichsweise dicke metallische Zwischenschichten einzusetzen, während zur Stabilisierung mehrere Keramikschichten dienen. Infolgedessen lässt sich der Wärmewiderstand reduzieren und gezielt eine Wärmespreizung einstellen. Insbesondere ist es vorgesehen, dass die Schichtdicke der aus Keramik gefertigten Primärschicht an die geforderte Isolationsfestigkeit angepasst ist. Dabei ist es vorstellbar, dass die erste Metallisierungsschicht, die zweite Metallisierungsschicht und/oder die Zwischenschicht jeweils aus mehreren metallischen Sub- bzw. Teilschichten zusammengesetzt sind, die beispielsweise wiederum untereinander mit einem Lotmaterial verbunden sind.

Zweckmäßigerweise ist die Primärschicht, insbesondere als Isolationsschicht, eine Keramikschicht.

Vorzugsweise weist die Isolationsschicht Al₂O₃, Si₃N₄, AIN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) oder ZTA als Material für die Keramik auf. Es ist dabei auch vorstellbar, dass die Isolationsschicht als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Vorzugsweise wird eine hochwärmeleitfähige Keramik für einen möglichst geringen Wärmwiderstand verwendet.

Weiterhin ist es bevorzugt vorgesehen, dass das Trägersubstrat mit der Primärschicht, der Sekundärschicht und der metallischen Zwischenschicht als Aufbau aus fünf oder mehr Lagen zusammengesetzt ist. Insbesondere ist für den fünflagigen Aufbau vorgesehen das zwei metallische Zwischenschichten zwischen der Primärschicht und der Sekundärschicht vorgesehen sind, wobei zwischen den zwei metallischen Zwischenschichten eine Tertiärschicht angeordnet ist. Vorzugsweise weisen mindestens zwei Schichten ein vergleichsweise hohes E-Modul auf. Dadurch wird die Verwindungsneigung bei betriebs- und umgebungsbedingten Temperaturwechseln weiter reduziert. Vorzugsweise sind die Primärschicht, die Sekundärschicht und/oder die Tertiärschicht aus einem Keramik umfassenden Material gefertigt, beispielsweise aus einem der weiter oben genannten Keramiken. Dadurch lassen sich in vorteilhafter Weise die gewünschten Anforderungen an die Isolationsfestigkeit realisieren. Es ist aber auch vorstellbar, dass die Sekundärschicht und/oder Tertiärschicht nicht aus einem eine Keramik umfassenden Material gefertigt sind, da diese im Wesentlichen zur Versteifung des Trägersubstrats dienen und nicht zur Isolation beitragen. Denkbar wäre beispielsweise hier die Verwendung von Molybdän und/oder Wolfram statt einer Keramik.

Gemäß einer bevorzugten Ausführungsform ist es vorgesehen, dass die Primärschicht, die Zwischenschicht und die Sekundärschicht in Stapelrichtung übereinander angeordnet sind und die erste Aussparung und zweite Aussparung in Stapelrichtung gesehen übereinander, insbesondere fluchtend zueinander, angeordnet sind. Durch die in Stapelrichtung gesehen fluchtende Anordnung ist es möglich, über die zweite Aussparung kommend die erste Aussparung zu verfüllen. Besonders bevorzugt ist es vorgesehen, dass ein parallel zur Haupterstreckungsebene bemessener Querschnitt der ersten Aussparung größer ist als ein parallel zur Haupterstreckungsebene bemessener Querschnitt der zweiten Aussparung. Dadurch lässt sich in vorteilhafter Weise die Wahrscheinlichkeit erhöhen, dass beim Ausbilden der zweiten Aussparung diese oberhalb der ersten Aussparung mündet bzw. ein seitlicher Versatz nicht eine die Leitfähigkeit beeinträchtigende Querschnittsverjüngung im Übergangsbereich zwischen der ersten Aussparung und der zweiten Aussparung bedingt.

Besonders bevorzugt ist es vorgesehen, dass die zweite Aussparung zeitlich nach der Verkapselung und/oder die erste Aussparung zeitlich vor der Verkapselung realisiert wird. D. h. es wird zunächst das Trägersubstrat mit der ersten Aussparung in der Primärschicht verkapselt und anschließend erst die zweite Aussparung gebildet. Dies erweist sich für das Ausbilden einer stabilen Verkapselung als vorteilhaft. Beispielsweise erfolgt die Ausbildung der ersten und/oder zweiten Aussparung mittels einer Bohrung. Es ist auch vollstellbar, dass die zweite Aussparung beim Spitzguss bzw. Spritzpressverfahren realisiert wird. Dadurch lässt sich das an das Verkapseln anschließende Ausbilden der zweiten Aussparung verzichten. Alternativ ist es vorstellbar, dass die erste Aussparung nach der Verkapselung realisiert wird, beispielsweise indem erst die zweite Aussparung ausgebildet wird und der mit der zweiten Aussparung freigelegte Teil der Primärschicht mit der ersten Aussparung versehen wird.

In einer besonders bevorzugten Ausführungsform der vorliegenden Erfindung ist es vorgesehen, dass die zweite Aussparung während des Verkapselns realisiert wird, insbesondere unter Verwendung einer ersten Werkzeughälfte und einer zweiten Werkzeughälfte, wobei die erste Werkzeughälfte und die zweite Werkzeughälfte in einem geschlossenen Zustand einen Hohlraum ausbilden, der das Trägersubstrat zumindest teilweise umgibt, wobei die zweite Aussparung beim Verfüllen durch ein Freistellen mittels eines innerhalb des Hohlraums angeordneten Teils eines Stempelelements, realisiert wird. Durch das zeitgleiche Herstellen der zweiten Aussparung kann in vorteilhafter Weise auf eine Ausbildung der zweiten Aussparung im Nachgang an das Verkapseln verzichtet werden. Ein weiterer Vorteil besteht darin, dass auf die Ausbildung mittels einer Laserbohrung verzichtet werden kann. Dabei hat es sich als besonders vorteilhaft erwiesen ein verschiebbar gelagertes Stempelelement zu nutzen, dass fertigungstoleranzbedingte Unebenheiten am Trägersubstrat berücksichtigen kann, wodurch sich die zweiten Aussparungen prozesssicher realisieren lassen. Dabei wird das Stempelelement vorzugsweise beim Verfüllen oberhalb der ersten Aussparung und/oder innerhalb der Aussparung angeordnet. Beispielsweise setzt das Stempelelement auf der Primärschicht auf und bedeckt die erste Aussparung, insbesondere deckt das Stempelelement die erste Aussparung vollständig ab. In einer alternativen Ausführungsform ragt das Stempelelement in die erste Aussparung hineein und gerät besonders bevorzugt mit der Zwischenschicht in Anschlag. Dadurch wird sichergestellt, dass sich eine direkte Durchkontaktierung zu der Zwischenschicht im Nachgang an das Verkapseln realisieren lässt.

In einer weiteren Ausführungsform der vorliegenden Erfindung ist es vorgesehen, dass die zweite und/oder die dritte Aussparung mittels Laserlicht, insbesondere durch Laserfreischneiden, realisiert wird. Dadurch lassen sich die zweite Aussparung und die dritte Aussparung positionsgenau und präzise realisieren. Die durch Laserlicht hergestellte zweite und/oder dritte Aussparung zeichnet sich durch ihren in Richtung des Trägersubstrats verjüngenden Querschnitt, insbesondere konischen Verlauf, aus. Es ist ferner vorstellbar, dass die erste Aussparung ebenfalls mittels Laserlicht realisiert wird. Dabei wird vorzugsweise für die Ausbildung der ersten Aussparung ein anderes Licht, beispielsweise sich hinsichtlich einer Wellenlänge, einer Intensität und/oder Strahlprofils unterscheidendes Licht, verwendet, im Vergleich zur Herstellung der zweiten und der dritten Aussparung. Um die Durchkontierung richtig zu platzieren, lässt sich ein Rand der Verkapselung oder eine Kennzeichnung auf der Verkapselung als Referenz verwenden.

Vorzugsweise ist es vorgesehen, dass das Füllen der ersten Aussparung, der zweiten Aussparung und/oder der dritten Aussparungen mittels eines galvanischen Prozesses realisiert wird. Alternativ ist es vorstellbar, dass die Durchkontaktierung und/oder die weitere Durchkontaktierung nasschemisch, durch eine Paste, eine Gasphasenabscheidung, ein Siebdruckverfahren, ein 3D-Druckverfahren und/oder mechanisch realisiert wird.

Insbesondere ist es vorgesehen, dass die erste Metallisierungsschicht eine vierte Aussparung aufweist, wobei zum Ausbilden der Durchkontaktierung zum Bereitstellen einer elektrischen Verbindung zwischen einem zweiten elektronischen Bauteil an einer Außenseite der Verkapselung und der metallischen Zwischenschicht die erste Aussparung in der Primärschicht, die zweite Aussparung in der Verkapselung und die vierte Aussparung in der ersten Metallisierungsschicht in einem Arbeitsschritt mit einem elektrisch leitfähigen Material gemeinsam gefüllt werden. Es ist für den Fachmann ersichtlich, dass die vierte Aussparung dann erforderlich ist, wenn die Durchkontaktierung über einen Teil der Primärschicht erfolgen soll, der mit der ersten Metallisierungsschicht bedeckt ist. Grundsätzlich ist es aber auch vorstellbar, dass die Durchkontaktierung in einem Teilbereich der Primärschicht erfolgt, die frei von einer Metallisierungsschicht ist. Bevorzugt wird die vierte Aussparung mittels einen Ätzverfahrens und/oder eines Fräsverfahrens realisiert. Es ist dabei vorstellbar, dass die Ausbildung der vierten Aussparung vor und/oder nach der Verkapselung erfolgt.

Gemäß einer bevorzugten Ausführungsform der vorliegenden Erfindung ist es vorgesehen, dass die Zwischenschicht
- dicker als die Primärschicht und/oder die Sekundärschicht ist und/oder
- dicker als 1 mm, bevorzugt dicker als 1,5 und besonders bevorzugt dicker als 2,5 mm ist.

Derartig dicke metallische Zwischenschichten wirken in vorteilhafter Weise als temporärer Speicher und verbessern so die thermische Impedanz Zₜₕ. Dabei unterstützt die Dicke insbesondere die Wärmespreizung beim Wärmeabtransport, bei dem die Wärme von der Bauteilseite über das Trägersubstrat auf eine der Bauteilseite gegenüberliegende Seite des Trägersubstrats geleitet wird. Insbesondere ist es vorgesehen, dass die Zwischenschicht einlagig bzw. einstückig ausgestaltet ist. Die Zwischenschicht kann vorzugsweise als elektrische Rückleiter dienen, indem eine zusätzliche Durchkontaktierung in der Primärschicht eingelassen ist, so dass nicht nur die erste Metallisierungsschicht zur Stromführung genutzt werden kann, sondern auch die metallische Zwischenschicht.

Weiterhin ist es bevorzugt vorgesehen, dass sich die Durchkontaktierung bis zur Kühlstruktur erstreckt. Die bis zur Kühlstruktur durchgreifende Durchkontaktierung erweist sich insbesondere deswegen als vorteilhaft, weil dadurch eine Erdung vorgenommen werden kann, die insbesondere an der Außenseite der Verkapselung bereitgestellt werden kann. Dabei ist es zweckmäßig vorgesehen, dass die Zwischenschicht derart vorstrukturiert wird bzw. strukturiert ist, dass bei der Durchkontaktierung ein Teil der Zwischenschicht isoliert bleibt von der Durchkontaktierung, um einen Kurzschluss zu vermeiden und die Zwischenschicht, insbesondere den Teil der Zwischenschicht, über den die Durchkontaktierung nicht bis zur Kühlstruktur durchläuft, weiterhin als Rückleiter zu nutzen. Dabei kann die Kühlstruktur Finnen umfassen oder als massiver Metallblock ausgebildet sein.

In einer bevorzugten Ausführungsform der vorliegenden Erfindung ist es vorgesehen, dass das Elektronikmodul und/oder das Trägersubstrat thermomechanisch symmetrisch ausgestaltet ist, insbesondere entlang einer Stapelrichtung, die senkrecht zu einer Haupterstreckungsebene des Trägersubstrats verläuft. Unter einer thermomechanische symmetrischen Ausbildung ist insbesondere zu verstehen, dass thermomechanische Ausdehnungskoeffizienten in Stapelrichtung gesehen symmetrisch sind. Der thermomechanische Ausdehnungskoeffizient ist dabei ein Maß für die Ausdehnung der jeweiligen Schicht bei einem Temperaturwechsel bzw. einer Temperaturänderung. Vorzugsweise lässt sich das Elektronikmodul in virtuelle Teilsubstrate unterteilen, insbesondere mit einem virtuellen Primärsubstrat, einem virtuellen Sekundärsubstrat und einer virtuellen Zwischenschicht und die thermischen Ausdehnungskoeffizienten der virtuellen Teilsubstrate sind symmetrisch in Stapelrichtung verteilt. Durch die symmetrische Gestaltung der Ausdehnungskoeffizienten wird in vorteilhafter Weise ein Elektronikmodul bereitgestellt, das vergleichsweise verwindungsarm ist gegenüber betriebsbedingten bzw. umgebungsbedingten Temperaturwechseln. Infolgedessen lassen sich Defekte bzw. Risse vermeiden, die andernfalls durch thermisch induzierte mechanische Spannungen veranlasst werden würden. Insbesondere zusammen mit einem Trägersubstrat mit einer vergleichsweise dicken metallischen Zwischenschicht, insbesondere über 1 mm, ist es dabei möglich, einen vergleichsweise hohen thermischen Ausdehnungskoeffizienten für das gesamte Trägersubstrat bereitzustellen. Infolgedessen vereinfacht sich die Anpassung des thermischen Ausdehnungskoeffizienten für die Verkapselung des Elektronikmoduls, da der Aufwand zur Reduktion des typischerweise hohen thermischen Ausdehnungskoeffizienten der Verkapselung reduziert werden kann. Zum Reduzieren des thermischen Ausdehnungskoeffizienten wird schließlich ein Füllmaterial in das Material der Verkapselung eingelassen. Durch die erhöhten Ausdehnungskoeffizienten für das Trägersubstrat lässt sich die Menge des Füllmaterials reduzieren, wodurch wiederum Kosten für die Fertigung des Elektronikmoduls reduziert werden.

In einer weiteren Ausführungsform der vorliegenden Erfindung ist es vorgesehen, dass in der Verkapselung eine zwischen der Außenseite der Verkapselung und der Bauteilseite des Trägersubstrats angeordnete Kontaktierungsebene vorgesehen ist, die zum Verbinden mindestens zweier Durchkontaktierungen und/oder weiterer Durchkontaktierungen schräg und/oder quer zur Erstreckungsrichtung/Verlaufsrichtung der Durchkontaktierungen bzw. weiteren Durchkontaktierung verläuft. Dadurch lassen sich mehrere Durchkontaktierungen innerhalb der Verkapselung miteinander elektrisch verbinden, so dass der Bereich innerhalb der Verkapselung bereits als Verteilsystem, d. h. als dreidimensionales Leitersystem, genutzt werden kann. Ferner ist es vorstellbar, mittels der Kontaktierungsebene die weitere Durchkontaktierung mit einer oder mehrerer Durchkontaktierungen zu verbinden. Vorzugsweise erstrecken sich die Kontaktierungsebenen parallel zur Haupterstreckungsebene des Trägersubstrats und sind als zusätzliche strukturierte Metallisierungsschicht ausgebildet. Zur Fertigung solcher Kontaktierungsebenen ist es beispielsweise vorstellbar, dass die Verkapselung mehrteilig zusammensetzbar ist oder in mehreren aufeinanderfolgenden Spritzguss und/oder Spritzpressenvorgängen realisiert wird. Weiterhin gestatten die Kontaktierungsebenen auf einfache Weise einen lateralen Versatz zwischen dem ersten Bauteil und dem zweiten Bauteil zu realisieren, insbesondere ohne schräg zur Stapelrichtung verlaufende Durchkontaktierungen.

Erfindungsgemäß ist es vorgesehen, dass das Trägersubstrat an seiner der Bauteilseite gegenüberliegenden Seite eine Kühlstruktur aufweist, wobei das Elektronikmodul vorzugsweise ein Dichtelement und/oder Dichtmaterial, z. B. ein Silikon, für ein fluiddichtes Anbinden an eine Fluidkühlungsvorrichtung aufweist. Insbesondere ist die Kühlstruktur in vorteilhafter Weise in das Trägersubstrat integriert und wird von der Verkapselung nicht umschlossen, d. h. liegt frei. Die Integration gestattet einen geringen Aufwand beim Verbauen des Elektronikmoduls, da in vorteilhafter Weise auf einen zusätzlichen Arbeitsschicht, in dem eine Bodenplatte und/oder ein Kühler an das Trägersubstrat angebunden wird, beispielsweise gelötet, gesintert und/oder verklemmt wird, verzichtet werden kann. Die Fluidkühlvorrichtung dient insbesondere dem Heran - und Abführen eines Kühlfluids, insbesondere einer Kühlflüssigkeit. Vorzugsweise umfasst die Kühlstruktur Finnen, die in einen Kanal hineinragen, der von der Kühlstruktur und der Fluidkühlungsvorrichtung ausgebildet wird. Zum Abdichten des Kanals, der zwischen trägersubstratseitigen Kühlstruktur und Fluidkühlungsvorrichtung ausgebildet wird, ist vorzugsweise ein Dichtelement vorgesehen, das in das Elektronikmodul integriert ist, vorzugsweise im Wesentlichen in Stapelrichtung gesehen auf Höhe der Kühlstruktur angeordnet ist. Vorzugsweise ist das Dichtelement ringartig oder als Wulst ausgebildet und umläuft vorzugsweise die Kühlstruktur, insbesondere die Finnen der Kühlstruktur. Vorzugsweise ist das Dichtelement an der Verkapselung angeordnet, beispielsweise in einer hierfür vorgesehenen Nut.

Ein weiterer Vorteil, der sich durch Integration der Kühlstruktur unmittelbar an das Trägersubstrat ergibt, ist, dass man auf Material zwischen der Kühlstruktur und dem Trägersubstrat bzw. der Sekundärschicht verzichten kann. Solch ein TIM (thermal interface material) Material weist in der Regel eine gegenüber den übrig verwendeten Materialen im Trägersubstrat reduzierte Wärmleitfähigkeit auf. Der Verzicht auf das TIM Material und das Vermeiden von Grenzflächen verbessert den thermischen Widerstand des Trägersubstrats bzw. des Elektronikmoduls signifikant.

In einer weiteren Ausführungsform der vorliegenden Erfindung ist es vorgesehen, dass die Durchkontaktierung und/oder die weitere Durchkontaktierung eine Länge zwischen 0,1 und 15 mm, bevorzugt zwischen 0,15 und 8 mm und besonders bevorzugt zwischen 0,2 und 5 mm aufweist. Es hat sich in vorteilhafter Weise herausgestellt, das mit derartig kurzen Leiterpfaden bzw. Durchkontaktierungen, der Einfluss von parasitären Induktivitäten deutlich reduzieren lässt und die Ansteuerung der ersten elektronischen Bauteil durch die zweiten elektronischen Bauteile so verbessert wird.

Zum Bereitstellen des Trägersubstrats werden beispielsweise eine Primärschicht, eine Sekundärschicht, eine Zwischenschicht, eine erste Metallisierungsschicht und/oder eine Kühlstruktur in einem gemeinsamen Anbindungsverfahren miteinander verbunden. Dabei können auch unterschiedliche Anbindungsverfahren verwendet werden. Als Anbindungsverfahren kommen z. B. DCB- (direct copper bonding) oder DAB (direct aluminium bonding)-Verfahren, in Frage oder das Verbinden mittels eines Aktivlots, d. h. ein AMB (active metal brazing) - Verfahren. Dabei wird das Trägersubstrat mit einer Primärschicht bereitgestellt, die eine Aussparung aufweist.

Vorzugsweise werden die ersten elektronischen Bauteile so präpariert bzw. bereitgestellt, dass sie eine Kontaktfläche aufweisen, die im am Trägersubstrat verbauten Zustand auf die Außenseite bzw. der weiteren Durchkontaktierung zugewandt sind. Dabei ist es vorstellbar, dass Kontaktierungslöcher in das erste elektronische Bauteil eingelassen werden und Anschlusskontaktierung mittels physikalischer Gasphasenablagerung realisiert werden. Anschließend wird die Anschlusskontaktierung durch ein chemisches Ablagern, beispielsweise mittels einer Galvanotechnik, verstärkt. Vorzugsweise werden die ersten elektronischen Bauteile bzw. Gruppierungen aus ersten elektronischen Bauteilen mit den gewünschten Kontaktflächen bereitgestellt.

Vorzugsweise ist es vorgesehen, dass die Verkapselung mittels eines Spritzguss und/oder Spritzpressverfahrens geformt wird, insbesondere um das bestückte Trägersubstrat herum geformt wird. Insbesondere wird die Verkapselung in einem Spritzguss und/oder Spritzpressenformteil geformt. Dabei wird vorzugsweise das bestückte Trägersubstrat, insbesondere an der Bauteilseite, mit dem Spritzguss und/oder Spritzpressenmaterial bedeckt, nachdem es in das Spritzguss und/oder Spritzpressenformteil eingesetzt wurde. Als Spritzguss und/oder Spritzpressenverfahren ist beispielsweise ein Transfermolding, ein Kompressionsmolding und/oder ein Flüssigvergussverfahren vorstellbar. Sofern eine oder mehrere Kontaktierungsebenen vorgesehen sind, ist es vorstellbar, dass die Verkapselung in mehreren aufeinander folgenden Spritzguss- und/oder Spritzpressenvorgängen realisiert wird, wobei zwischen jedem dieser Spritzguss und/oder Spritzpressenvorgängen eine Kontaktierungsebene mit oder ohne weitere Bauelemente realisiert wird, indem ein strukturierte Metallisierungsschicht auf den zuletzt gegossenen Abschnitt der Verkapselung aufgebracht wird.

In einer weiteren Ausführungsform der vorliegenden Erfindung ist es vorgesehen, dass die zweite Metallisierungsschicht auf der Außenseite der Verkapselung
- durch eine während des Spritzguss und/oder Spritzpressenverfahrens in eine Spritzguss und/oder Spritzpressenform eingelegte Metallfolie,
- durch eine physikalische Gasphasenabscheidung und/oder
- elektrochemische Abscheidung
realisiert wird. Insbesondere dient die elektrochemische Abscheidung, beispielsweise mittels Galvanotechnik, der Verstärkung derjenigen Struktur, die durch die Metallfolie bzw. die physikalische Gasphasenabscheidung bereits begonnen bzw. initiiert wurde. Beispielsweise wird durch die Gasphasenabscheidung oder die Metallfolie bereitgestellte Struktur durch galvanisches Kupfer verstärkt, insbesondere nach oder vor einer Strukturierung. Dabei wird bei der Gasphasenabscheidung beispielsweise eine Schablone verwendet. Sofern eine Metallfolie zur Realisierung der zweiten Metallisierungsschicht vorgesehen ist, ist es vorstellbar, dass diese Metallfolie bereits strukturiert ist. Alternativ oder ergänzend ist es denkbar, dass die zweite Metallisierungsschicht nach ihrer Fertigung strukturiert wird. Ferner ist es auch vorstellbar, dass die zweite Metallisierungsschicht auf der Verkapselung aufgeklebt wird. Weiterhin ist es vorstellbar, dass die zweite Metallisierungsschicht mittels eines Druckverfahrens, insbesondere eines 3D-Druckverfahrens, aufgetragen wird. Ferner ist es denkbar, dass nach dem Bereitstellen der zweiten Metallisierungsschicht diese nachbearbeitet wird. Beispielsweise wird die zweite Metallisierungsschicht versiegelt (mit Gold; Silber, ENIG) und/oderlötbar gemacht.

Es geht insbesondere um die Herstellung eines Elektronikmoduls, umfassend
- eine Verkapselung, und
- ein zumindest teilweise in die Verkapselung eingebettetes Trägersubstrat mit einer Bauteilseite, die eine erste Metallisierungsschicht aufweist und an der mindestens ein erstes elektronisches Bauteil angeordnet ist, wobei an einer Außenseite der Verkapselung mindestens eine zweite Metallisierungsschicht für mindestens ein zweites elektronisches Bauteil, insbesondere zur Steuerung des ersten elektronischen Bauteils, vorgesehen ist, wobei das Trägersubstrat eine Primärschicht, eine Sekundärschicht und eine zwischen der Primärschicht und der Sekundärschicht angeordnete metallische Zwischenschicht, insbesondere als elektronischer Rückleiter, aufweist, wobei zur elektronischen Verbindung der Zwischenschicht mit dem zweiten elektronischen Bauteil eine Durchkontaktierung vorgesehen ist, wobei die Durchkontaktierung durch die Verkapselung und die Primärschicht verläuft.

Alle für das erfindungsgemäße Verfahren beschriebenen Merkmale und deren Vorteile lassen sich sinngemäß ebenfalls auf das erfindungsgemäße Verfahren übertragen und vice versa.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsform können dabei im Rahmen der Erfindung miteinander kombiniert werden.

Es zeigt:
- **Fig.1:**: ein Elektronikmodul gemäß einer ersten beispielhaften Ausführungsform der vorliegenden Erfindung vor Ausbildung der Durchkontaktierung,
- **Fig. 2:**: das Elektronikmodul gemäß der ersten beispielhaften Ausführungsform der vorliegenden Erfindung nach Ausbildung der Durchkontaktierung,
- **Fig. 3:**: schematisch ein Verfahren zur Herstellung eines Elektronikmoduls gemäß einer beispielhaften Ausführungsform der vorliegenden Erfindung,
- **Fig. 4.**: ein Beispiel für eine Fertigung eines Vorverbundes
- **Fig. 5**: ein Elektronikmodul gemäß einer zweiten beispielhaften Ausführungsform der vorliegenden Erfindung vor Ausbildung der Durchkontaktierung,
- **Fig. 6**: ein Elektronikmodul gemäß einer dritten beispielhaften Ausführungsform der vorliegenden Erfindung vor Ausbildung der Durchkontaktierung und
- **Fig. 7a/7b**: Elektromodule, hergestellt mit einem Verfahren gemäß einer vierten und einer fünften bespielhaften Ausführungsform der vorliegenden Erfindung.

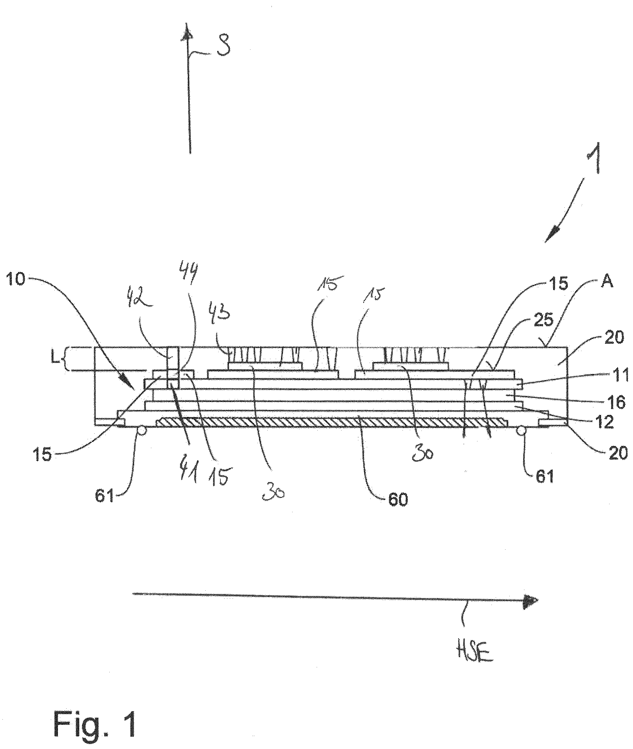

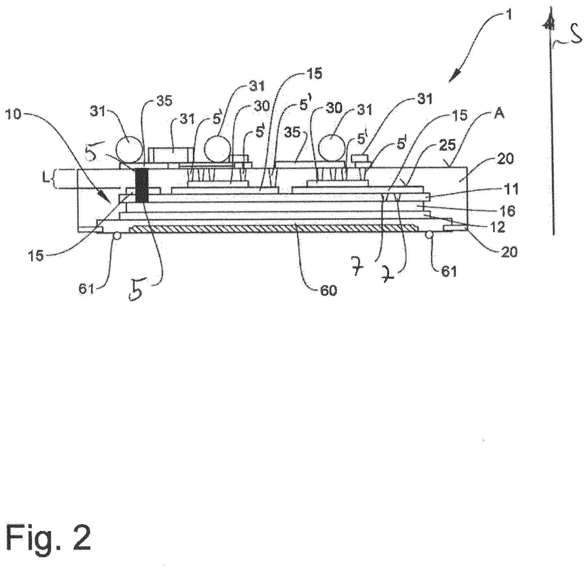

In den **Figuren 1** **und** **2** ist ein Elektronikmodul 1 gemäß einer ersten beispielhaften Ausführungsform der vorliegenden Erfindung dargestellt. Wesentliche Bestandteile eines solchen Elektronikmoduls 1 sind ein Trägersubstrat 10 und eine Verkapselung 20, wobei das Trägersubstrat 10 zumindest teilweise in die Verkapselung 20 eingebettet ist, d. h. das Trägersubstrat 10 ist zumindest teilweise in die Verkapselung 20 eingekapselt. Das Trägersubstrat 10 weist eine Bauteilseite 25 mit einer ersten Metallisierungsschicht 15 auf, wobei die erste Metallisierungsschicht 15 zur Bildung von Leiterbahnen oder Anschlusspads strukturiert ist. An der Bauteilseite 25 des Trägersubstrats 10 sind erste elektronische Bauteile 30 angebunden, die zur Ausbildung zumindest eines Teils eines elektronischen Schaltkreises vorzugsweise untereinander verbunden sind. Beispielsweise umfassen die erste elektronischen Bauteile 30 Halbleiter, insbesondere WBG -Halbleiter (wide bandgap semiconductors), wie z. B. einem Halbleiter aus Siliziumcarbid, Galliumnitrid und/oder Indiumgalliumnitrid, deren Bandlücke zwischen einem Valenzband und dem Leitungsband zwischen 2 eV und 4 eV oder darüber liegt. Insbesondere ist das Elektronikmodul 1 ein Leistungselektronikmodul und dient beispielsweise der Umformung elektrischer Energie mit schaltenden, elektronischen Bauteilen. Denkbar wäre z. B. dass das Elektronikmodul als Gleichspannungswandler, Umrichter und/oder Frequenzumrichter im Bereich der elektronischen Antriebstechnik, insbesondere im Bereich der E-mobilität, als Solarwechselrichter und/oder Umrichter für Windkraftanlagen zur Netzeinspeisung regenerativ erzeugter Energie oder als Schaltnetzteil bzw. DC-DC-Wandler eingesetzt wird.

Zur Steuerung der ersten elektronischen Bauteile 30 auf der Bauteilseite 25 ist an der Außenseite A der Verkapselung 20 eine insbesondere als Anschluss dienende zweite Metallisierungsschicht 35 für mindestens ein zweites elektronisches Bauteil 31 oder Kontaktelement vorgesehen. Vorzugsweise ist die zweite Metallisierungsschicht 35 ebenfalls strukturiert. Beispielsweise handelt es sich bei dem zweiten elektronischen Bauteil 31 um ein Steuerungselement, wie z. B. einen Gate-Treiber, ein Zwischenkondensator, ein Lastanschluss, ein Anschluss zur Energieversorgung oder Vergleichbares.

Vorzugsweise umfasst das Trägersubstrat 10 eine Primärschicht 11, eine Sekundärschicht 12 und eine zwischen der Primärschicht 11 und der Sekundärschicht 12 angeordnete, metallische Zwischenschicht 16. Hierbei erstrecken sich die Primärschicht 11, die Sekundärschicht 12 und die Zwischenschicht 16 entlang einer Haupterstreckungsebene HSE und sind entlang einer senkrecht zur Haupterstreckungsebene HSE verlaufenden Stapelrichtung S übereinander angeordnet. Dabei dient die metallische Zwischenschicht 16 vorzugsweise als elektrischer Rückleiter, wodurch mit Vorteil parasitäre Induktivitäten reduziert werden können. Während die Primärschicht 11 und/oder die Sekundärschicht 12 primär zur Versteifung des Trägersubstrats 10 vorgesehen sind, dient die Zwischenschicht 16, neben ihrer optionalen Funktion als elektrischer Rückleiter (wenn eine Durchkontaktierung durch die Primärschicht vorliegt), insbesondere als Wärmesenke bzw. temporärer Wärmespeicher, in der eine (zusätzliche) Wärmspreizung erfolgt. Als temporärer Wärmespeicher verbessert die Zwischenschicht 16 eine thermische Impedanz Zₜₕ des Trägersubstrats 10. Die Wärmespreizung führt in vorteilhafter Weise auf eine homogener Temperaturverteilung auf einer der Bauteilseite 25 des Trägersubstrats 10 gegenüberliegenden Seite des Trägersubstrats 10, über die die von den ersten elektronischen Bauteilen 30 entwickelte Wärme über eine Kühlstruktur 60 oder eine andere Kühlvorrichtung abgeleitet werden soll. Vorzugsweise ist die Zwischenschicht 16 hierzu dicker als die Primärschicht 11 und/oder die Sekundärschicht 12 ist und/oder dicker als 1 mm, bevorzugt dicker als 1,5 und besonders bevorzugt dicker als 2,5 mm.

Vorzugsweise sind die thermischen Ausdehnungskoeffizienten bzw. die Ausdehnung der einzelnen Komponenten des Elektronikmoduls 1 derart gewählt, dass der thermische Ausdehnungskoeffizient in Stapelrichtung S gesehen im Wesentlichen symmetrisch bzw. möglichst symmetrisch ist. Bei einer Nutzung der metallischen Zwischenschicht 16 mit einer Dicke größer als 1 mm und der Verwendungen dünnerer Primärschichten 11 bzw. Sekundärschichten 12, insbesondere aus Keramik, ist es dann in vorteilhafter Weise möglich für das Trägersubstrat 10 einen vergleichsweise hohen thermischen Ausdehnungskoeffizienten CTE zu realisieren. Dieser vergleichsweise hohe thermische Ausdehnungskoeffizient vereinfacht die Anpassung des thermischen Ausdehnungskoeffizienten der Verkapselung 20, der andernfalls mittels eines entsprechenden Füllmaterials gesenkt werden müsste. Infolgedessen lässt sich in vorteilhafter Weise die Materialkosten für das Füllmaterial reduzieren.

Für eine möglichst kompakte Bauform sorgt insbesondere die Verkapselung 20. Insbesondere ist die Verkapselung 20 derart gestaltet, dass die Verkapselung 20 form-, kraft- und/oder formschlüssig mit dem Trägersubstrat 10 im zusammengesetzten Zustand zusammenwirkt. Vorzugsweise ist das Trägersubstrat 10 zumindest an seiner Bauteilseite 25 eingebettet in die Verkapselung 20, d. h. die Verkapselung 20 umschließt die Bauteilseite 25 vollständig. In der in Figur 1 dargestellten Ausführungsform ist auf einer der Bauteilseite 25 gegenüberliegenden Seite die Kühlstruktur 60 vorgesehen. Insbesondere umfasst die Kühlstruktur 60 Finnen. Weiterhin ist es vorgesehen, dass die Kühlstruktur 60 nicht von der Verkapselung 20 umhüllt ist, d. h. die Kühlstruktur 60 bzw. deren Finnen liegen frei. Stattdessen ist die Kühlstruktur 60 zur unmittelbaren Anbindung an eine Fluidkühlungsvorrichtung, beispielswiese einen entsprechenden Kanal, der ein Kühlfluid zur Kühlstruktur 60 hin und wegführt, vorgesehen. Zum Abdichten eines Fluidkanals, der zwischen der Fluidkühlungsstruktur bzw. -vorrichtung und der trägersubstratseitigen Kühlstruktur 60 ausgebildete wird, ist ein Dichtelement 61 vorgesehen. Vorzugsweise ist das Dichtelement 61 umlaufend in einer parallel zur Haupterstreckungsebene HSE verlaufenden Ebene ausgestaltet.

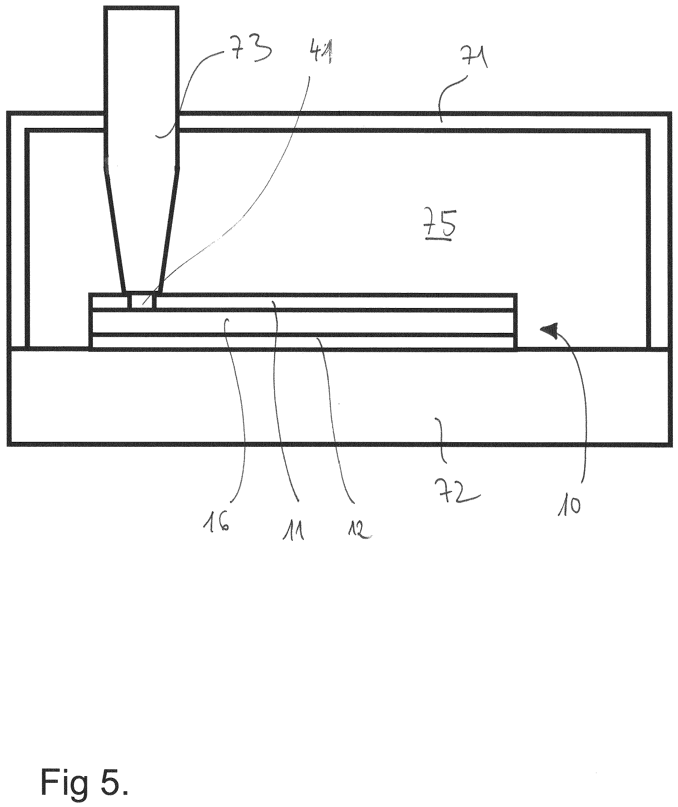

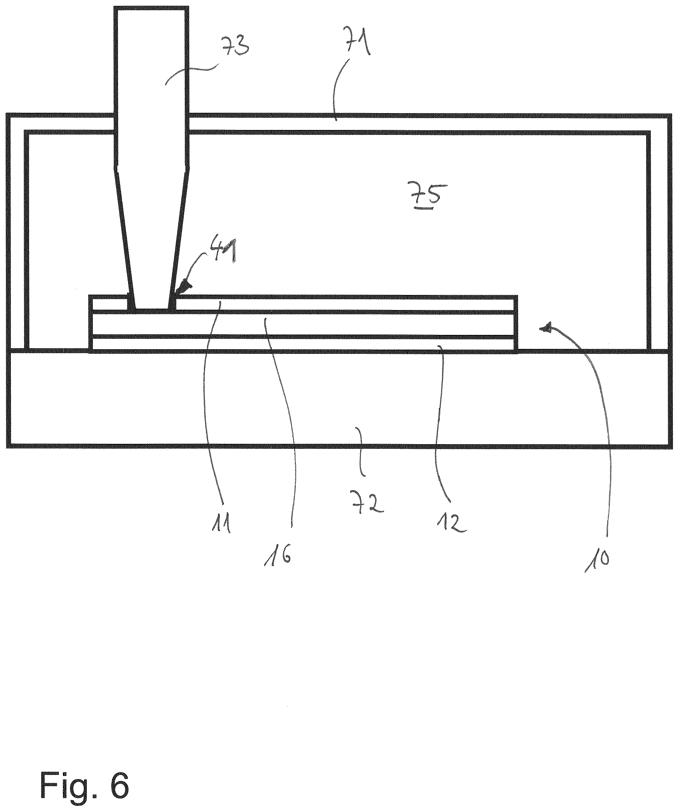

Insbesondere ist mindestens eine Durchkontaktierung 5 vorgesehen, die sich von der Außenseite A der Verkapselung 20 durch die Verkapselung 20 und durch die Primärschicht 11 des Trägersubstrats 10 hindurch bis in die Zwischenschicht 16 des Trägersubstrats 10 erstreckt. Hierzu ist es vorgesehen, dass beim Herstellen des Elektronikmoduls 1 das Trägersubstrat 10 derart bereitgestellt wird, dass dessen Primärschicht 11 eine erste Aussparung 41 aufweist. Es ist dabei vorstellbar, dass in einem vorgelagerten Arbeitsschritt die erste Aussparung 41 in der Primärschicht 11, beispielsweise durch eine Bohrung mittels Fräsen oder durch Laserlicht, realisiert wird. Das bereitgestellte Trägersubstrat 10 wird dann über die erste Metallisierungsschicht 15 mit elektrischen oder elektronischen ersten Bauteilen 30 und anschließend mit einer Verkapselung 20 versehen. In diese Verkapselung 20 wird wiederum eine zweite Aussparung 42 eingelassen, beispielsweise mittels Laserlicht oder durch ein Gussverfahren mit einem beweglichen Stempelelement (siehe Figuren 5 und 6). Dabei liegt die zweite Aussparung 42 vorzugsweise in Stapelrichtung S gesehen über der ersten Aussparung 41, insbesondere deckungsgleich über bzw. fluchtend zu der ersten Aussparung 41. Dabei ist es vorstellbar, dass die erste Aussparung 41 und die zweite Aussparung 42 in einer senkrecht zur Stapelrichtung S verlaufenden Ebene im Wesentlichen vergleichbare Querschnitte aufweisen. Es ist aber auch vorstellbar, dass der Querschnitt der ersten Aussparung 41 kleiner und/oder größer ist als der Querschnitt der zweiten Aussparung 42.

Weiterhin ist es vorgesehen, dass in der Verkapselung 20 dritte Aussparungen 43, beispielsweise mittels Laserlicht oder mittels eines mechanisches Bohren, realisiert werden, wobei sich die dritte Aussparungen 43 von der Außenseite A der Verkapselung 20 bis zur ersten Metallisierungsschicht 15 bzw. zum ersten elektronischen Bauteil 30 erstrecken. Die dritte Aussparung 43 wird zur Ausbildung einer weiteren Durchkontaktierung 5' genutzt, die die Außenseite A, insbesondere die zweite Metallisierungsschicht 35 an der Außenseite A mit der ersten Metallisierungsschicht 15 oder mit dem ersten elektronischen Bauteile 30 unmittelbar verbindet, d. h. ohne eine elektrische Leitung über die Zwischenschicht 16 zu nutzen. Neben der Durchkontaktierung 5 und der weiteren Durchkontaktierung 5' ist es vorstellbar, dass das Elektronikmodul 10 im gefertigten Zustand trägersubstrateigene Durchkontaktierungen 7 aufweist. Diese trägersubstrateigenen Durchkontaktierungen 7 sind bereits im bereitgestellten Trägersubstrat 10 realisiert. Beispielsweise unterscheidet sich die trägersubstrateigene Durchkontaktierung 7 von der Durchkontaktierung 5 und/oder der weiteren Durchkontaktierung 5', beispielsweise hinsichtlich des Herstellungsprozesses oder des Materials. Denkbar wäre z. B., dass die trägersubstrateigene Durchkontaktierung 7 beim Fertigungsprozesses des Trägersubstrats 10 mittels eines Lotverfahrens, insbesondere eines Hartlotverfahrens, hergestellt wird, bevor das Trägersubstrat 10 zum Verkapseln 102 bereitgestellt wird.

In dem in Figur 1 dargestellten Zustand ist neben der ersten Aussparung 41 in der Primärschicht 11, der zweiten Aussparung 42 und der dritten Aussparung 43 in der Verkapselung 20 eine vierte Aussparung 44 vorgesehen, die in der ersten Metallisierungsschicht 15 realisiert ist. Vorzugsweise wird das Trägersubstrat 10 mit der ersten Aussparung 41 und der vierten Aussparung 44 bereitgestellt, bevor ein Verkapseln 102 erfolgt.

Zur Vereinfachung des Fertigungsprozesses ist es vorgesehen, dass die Durchkontaktierung 5, die von der Außenseite A bis zur Zwischenschicht 16 verläuft, in einem gemeinsamen Arbeitsschritt realisiert wird, indem die erste Aussparung 41, die zweite Aussparung 42 und die vierte Aussparung 44 mit einem elektrisch leitfähigen Material gemeinsam verfüllt werden. Es ist für den Fachmann ersichtlich, dass auf eine vierte Aussparung 44 verzichtet werden kann, wenn die Durchkontaktierung 5 bis zur Zwischenschicht 16 in einem Bereich erfolgt, in dem das Trägersubrat 10 an seiner Bauteilseite 25 frei ist von Metall, d. h. die erste Metallisierungsschicht 15 eine entsprechende Unterbrechung aufweist. Weiterhin ist es bevorzugt vorgesehen, dass die Durchkontaktierung 5 durch einen galvanischen Prozess realisiert wird, wodurch die erste Aussparung 41, die zweite Aussparung 42 und die vierte Aussparung 44 mit dem elektrisch leitenden Material, vorzugsweise Kupfer, verfüllt werden.

Zum Bereitstellen einer unmittelbaren elektrischen Verbindung der ersten elektrischen Bauteile 30 und der zweiten elektronischen Bauteile 31 ist in der Verkapselung 20 ist zumindest eine weitere Durchkontaktierung 5' vorgesehen. Dabei erstreckt sich die weitere Durchkontaktierung 5' von der Außenseite A der Verkapselung 20 bis zur Bauteilseite 25 des Trägersubstrats 10. Vorzugsweise ist es vorgesehen, dass mittels der weiteren Durchkontaktierung 5 ein Abstand zwischen dem ersten elektrischen Bauteil 30 an der Bauteilseite 25 und dem zweiten elektrischen Bauteil 31 an der Außenseite A geringer als 10 mm, bevorzugt 5 mm, besonders bevorzugt 2,5 mm, insbesondere 1 mm bis hin zu weniger als 300 µm, d. h. möglichst gering, dimensioniert wird. Eine Länge L der weiteren Durchkontaktierung 5' entspricht dabei vorzugsweise dem Abstand zwischen dem ersten Bauteil 30 und dem zweiten Bauteil 31.

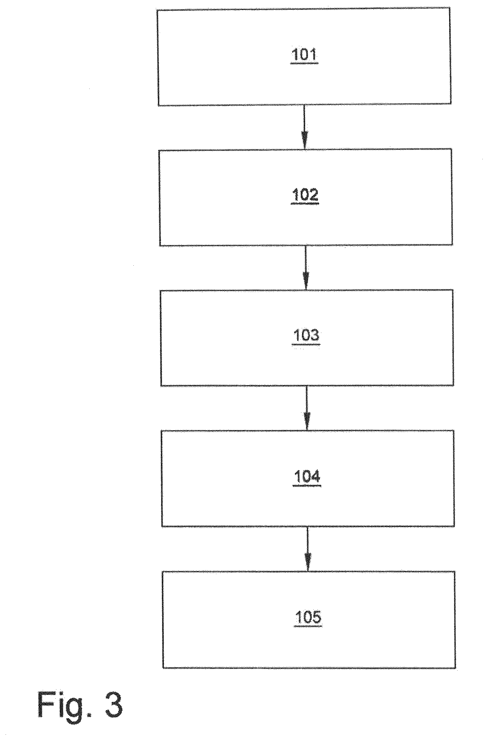

In **Figur 3** ist schematisch ein Verfahren zur Herstellung einer Elektronikmoduls 1 dargestellt. Dabei ist es vorgesehen, dass zunächst ein Trägersubstrat 10 bereitgestellt wird. Insbesondere werden zum Bereitstellen 101 des Trägersubstrats 10 die metallische Zwischenlage 16 und/oder eine Kühlstruktur 60 für das Trägersubstrat 10 vorbereitet. Anschließend werden die Primärschicht 11, die Sekundärschicht 12, die metallische Zwischenschicht 16 und/oder die Kühlstruktur 60 in einem gemeinsamen oder mehreren einzelnen Anbindungsprozessen miteinander verbunden. Bei dem Anbindungsprozess handelt es sich vorzugsweise um ein DCB- oder DAB-Verfahren oder ein Verbinden mittels eines Aktivlots. Zum Bereitstellen von Leiterbahnen und Anschlussflächen wird die erste Metallisierungsschicht 15 auf der Bauteilseite 25 strukturiert, beispielsweise durch einen Ätzprozess. Vorzugsweise wird die Bauteilseite 25 anschließend oberflächenmodifiziert, indem eine Vernickelung, ein Versilbern, ein Kantenverguss oder etwas Vergleichbares erfolgt. Insbesondere ist es vorgesehen, dass das Trägersubstrat 10 zum Bereitstellen 101 mit mindestens einer ersten Aussparung 41 in der Primärschicht 11 und/oder einer vierten Aussparung 44 in der ersten Metallisierungsschicht 15 versehen wird. Es ist auch vorstellbar, dass das bereitgestellte Trägersubstrat 10 zusätzlich zur ersten Aussparung 41 eine trägersubstrateigene Durchkontaktierung 7 aufweist.

Weiterhin ist es vorgesehen, dass die ersten elektronischen Bauteile 30 zur Anbindung an die Bauteilseite 25 für das Elektromodul 10 vorbereitet und beispielsweise als Vorverbund 50 bereitgestellt werden. Insbesondere werden an den ersten elektronischen Bauteilen 30 Kontakte derart realisiert, dass die Kontakte in einem im Elektronikmodul 1 verbauten Zustand der Außenseite A der Verkapselung 20 zugewandt sind. Hierzu werden Kontaktierungslöcher in dem Vorverbund 50 eingebracht. Die eingebrachten Kontaktierungen lassen sich mittels physikalischer Gasphasenabscheidung verkupfern und anschließend zur Verstärkung galvanisieren.

Nach dem Fertigstellen des Trägersubstrats 10 wird der Vorverbund 50 auf der strukturierten Metallisierungsschicht 15 an der Bauteilseite 25 des Trägersubstrats 10 befestigt, beispielsweise angelötet oder aufgesintert. Das mit dem Vorverbund 50 bestückte Trägersubstrats 10 wird anschließend verkapselt. Vorzugsweise wird zum Verkapseln 102 ein Spritzguss und/oder Spritzpressenverfahren verwendet. Hierzu wird das bestückte Trägersubstrat 10 in eine Spitzgussform eingelegt. Vorzugsweise ist die Spitzgussform so ausgestaltet, dass die Kühlstruktur 60 von einem beim Spritzgießen zu füllenden Hohlraum abgewandt ist. So wird die Kühlstruktur 60 beim Spritzguss und/oder Spritzpressenverfahren nicht vom beim Spritzguss und/oder Spritzpressen verwendeten Kunststoff bedeckt.

Weiterhin ist es vorgesehen, dass eine Ausbildung einer zweiten Aussparung 42 der Verkapselung 20 erfolgt, indem beispielsweise mittels Laserlichts eine zweite Aussparung 42, insbesondere ein Loch bzw. eine Bohrung, in der Verkapselung 20 realisiert wird. Dabei sind die Löcher und Bohrungen im Wesentlichen konisch geformt. Diese konische Form resultiert typischerweise aus einer Fokussierung eines Laserstrahls, mit dem die zweite Aussparung 42 realisiert wird. Dabei ist es insbesondere vorgesehen, dass in Stapelrichtung S gesehen die zweite Aussparung 42 oberhalb der ersten Aussparung 41 und/oder der vierten Aussparung 44 realisiert wird, wodurch ein freiliegender Kanal von der Außenseite A der Verkapselung 20 bis zur Zwischenschicht 16 geschaffen wird. Anschließend wird die erste Aussparung 41, die zweite Aussparung 42 und/oder die vierte Aussparung 44, d. h. das Loch bzw. die Bohrung zur Ausbildung der Durchkontaktierung 103 mit einem elektrisch leitfähigen Material, insbesondere einem Metall, gefüllt, beispielsweise unter Verwendung einer Paste oder durch galvanisches Auftragen. Zur Orientierung an der Außenseite A beim Realisieren der zweiten Aussparung 42 sind vorzugsweise Kennzeichnungen vorgesehen. Vorzugsweise handelt es sich bei der Kennzeichnung um in die Verkapselung 20 gefräste Löcher, die beispielsweise auch zur Ausrichtung der Verkapselung 20 vor dem Realisieren der Löcher dienen können.

Weiterhin ist vorstellbar, dass in eine verwendete Spitzgussform, mit der die Verkapselung gebildet wird, eine Metallfolie eingelegt wird, die nach dem Spritzguss und/oder Spritzpressen die zweite Metallisierungsschicht 35 für die zweiten elektronischen Bauteile 31 bildet. Ergänzend oder alternativ ist es vorstellbar, dass die zweite Metallisierungsschicht 35 nach dem Spritzguss und/oder Spritzpressenverfahren auf der spitzgegossenen Verkapselung 20 mittels eines physikalischen Gasphasenabscheidungsverfahren oder einem 3D Druckverfahren hergestellt wird. Vorzugsweise wird die zweite Metallisierungsschicht 35 durch ein mittels Galvanotechnik aufgetragenes Metall, beispielsweise durch galvanisch aufgetragenes Kupfer, verstärkt.

Zum Ausbilden einer strukturierten zweiten Metallisierungsschicht 104 gehört vorzugsweise ein Strukturieren der zweiten Metallisierungsschicht 35 an der Außenseite A. Es ist auch vorstellbar, dass ein Lötstopplacks verwendet und/oder die zweite Metallisierungsschicht 35 an der Außenseite A nachbehandelt wird. Als Nachbehandlung ist beispielsweise eine Oberflächenmodifikation 105 in Form eine Versiegelung mit ENIG (Electroless nickel immersion gold), Silber oder Gold vorstellbar. Vorzugsweise wird das zweite elektronische Bauteil 31 schließlich an der hierfür vorgesehenen zweiten Metallisierungsschicht 35 an der Außenseite A montiert. Weiterhin ist es vorgesehen, dass ein Deckelelement am Elektronikmodul 1 befestigt wird und das bereitgestellte Elektronikmodul 1 einer Endkontrolle unterzogen wird.

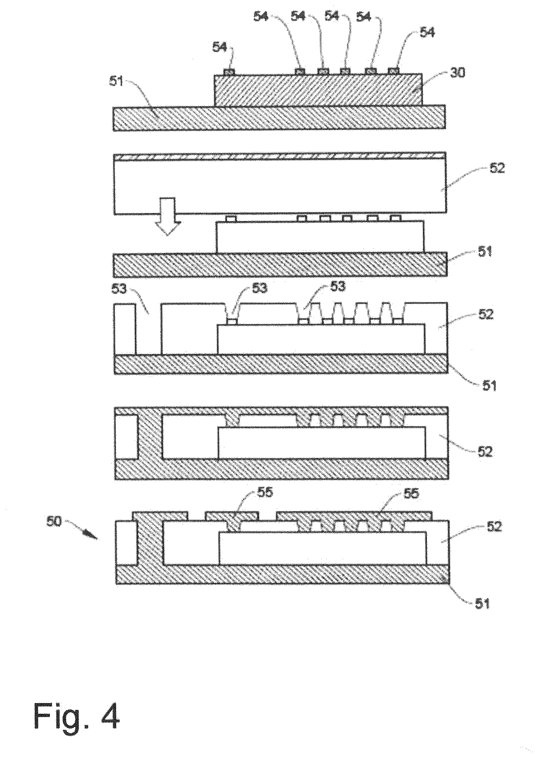

In **Figur 4** ist schematisch und beispielhaft ein Verfahren zur Fertigung eines Vorverbunds 50 dargestellt. Dabei ist es vorgesehen dass ein erstes elektronisches Bauteil 30 mit bauteilseitigen Anschlüssen 54 auf einer Leiterplatte 51 aufgebracht wird. Anschließend werden die Leiterplatte 51 und das erste Bauteil 30 derart laminiert, dass das erste Bauteil 30 innerhalb einer Matrix 52, beispielsweise einer dielektrischen Matrix 52, angeordnet bzw. eingebettet ist. Zum Freilegen der bauteilseitigen Anschlüsse 54 wird die dielektrische Matrix 52 strukturiert. Dadurch ergeben sich Aussparungen 53, die bis zur Leiterplatte 51 oder zu den elektrischen bauteilseitigen Anschlüssen 54 ragen. Diese Aussparungen 53 werden mit einem leitenden Material verfüllt, wobei auch die Außenseite der dielektrischen Matrix 52 bedeckt wird. Dann wird das leitende Material an der Außenseite strukturiert, um die vorverbundseitigen Kontaktflächen 55 bereitzustellen. Diese vorverbundseitigen Kontaktflächen 55 stellen die Kontaktflächen der ersten Bauteile 30 innerhalb der Verkapselung 20 dar und stehen mit der weiteren Durchkontaktierung 5' der Verkapselung 20 in Kontakt. Der Vorteil der Nutzung des Vorverbunds 50 besteht mitunter in der Realisierung von vorverbundseitigen Kontaktflächen 55, die größer sind als die bauteilseitigen Anschlüsse 54. So kann beispielsweise verhindert werden, dass wegen eines fertigungsbedingten Versatzes der nachträglich in die Verkapselung 20 eingelassene Durchkontaktierungen 5 keine Kontaktierung mit dem ersten Bauteil 30 bzw. dem Vorverbund 50 realisiert werden kann.

In **Figur 5** ist ein Elektronikmodul 1 gemäß einer zweiten beispielhaften Ausführungsform der vorliegenden Erfindung vor Ausbildung der Durchkontaktierung 5 dargestellt. Insbesondere ist es hierbei vorgesehen, dass die zweite Aussparung 42 in der Verkapselung 20 während dem Verkapseln 102 ausgebildet wird. Hierzu wird das Trägersubstrat 10 zunächst zwischen einer ersten Werkzeughälfte 71 und einer zweiten Werkzeughälfte 72 angeordnet. Bevorzugt wird das Trägersubstrat 10 durch die erste Werkzeughälfte 71 und/oder zweite Werkzeughälfte 72 verklemmt und/oder an der ersten Werkzeughälfte 71 und/oder der zweiten Werkzeughälfte 72 fixiert. Nach dem Positionieren des Trägersubstrats 10 zwischen der ersten Werkzeughälfte 71 und der zweiten Werkzeughälfte 72, werden die erste Werkzeughälfte 71 und die zweite Werkzeughälfte 72 in einen geschlossenen Zustand überführt, in dem die erste Werkzeughälfte 71 und die zweite Werkzeughälfte 72 einen Hohlraum 75 ausbilden, der zumindest teilweise das Trägersubstrat 10 umgibt. Durch Verfüllen dieses Hohlraums 75 mit einem entsprechenden Material und einem anschließenden Aushärten ist es in vorteilhafter Weise möglich, die Verkapselung 20 auszubilden.

Dabei ist es des Weiteren vorgesehen, dass eine Innenseite des Hohlraums 75 mit einem Film oder einer Folie verkleidet ist, die ein Herauslösen des Elektronikmoduls 1 beim Entformen vereinfacht. Besonders bevorzugt ist es vorgesehen, dass ein Stempelelement 73, das verschiebbar gelagert ist, in der ersten Werkzeughälfte 71 und/oder der zweiten Werkzeughälfte 72, vor dem Verfüllen in den Hohlraum 75 eingebracht wird. Der in den Hohlraum 75 eingebrachte Teil des Stempelelements 73 sorgt dann in vorteilhafter Weise beim Verfüllen für ein Freistellen desjenigen Bereichs im Hohlraum 75, in den er eingebracht wurde. Insbesondere ist es vorgesehen, dass der in den Hohlraum 75 eingebrachte Teil des Stempelelements 73 oberhalb der ersten Aussparung 41 angeordnet wird. Beim Verfüllen wird dann der von dem Teil des Stempelelements 73 in Beschlag genommene Bereich zur Ausbildung der zweiten Aussparung 42 freigestellt. In der in Figur 5 dargestellten Ausführungsform ist es dabei vorgesehen, dass das Stempelelement 73, insbesondere an seinem in den Hohlraum 75 hineinragenden Ende, an der Primärschicht 11, insbesondere an einer Oberseite der Primärschicht 11, anschlägt, d. h. beim Verfüllen des Hohlraums 75 die erste Aussparung 41 abdeckt, insbesondere vollständig bedeckt. Dadurch lässt sich in vorteilhafter Weise während des Verkapselns 102 die zweite Aussparung 42 ausbilden, die anschließend zusammen mit der ersten Aussparung 41 mit einem elektrisch leitenden Material zur Ausbildung der Durchkontaktierung 5 verfüllt werden. Weiterhin ist es bevorzugt vorgesehen, dass die erste Werkzeughälfte 71, die zweite Werkzeughälfte 72 und das Stempelelement 73 Entformungsschrägen aufweisen, die das Entformen des verkapselten Trägersubstrats 10 in vorteilhafter Weise nach dem Verfüllen und Aushärten erleichtern.

In der in **Figur 6** dargestellten Ausführungsform ist ein Elektronikmodul 1 gemäß einer zweiten beispielhaften Ausführungsform der vorliegenden Erfindung vor Ausbildung der Durchkontaktierung 5 dargestellt. Dabei unterscheidet sich das Herstellungsverfahren von demjenigen aus der Figur 5 im Wesentlichen nur dahingehend, dass das in den Hohlraum 75 hineinragende Ende des Stempelelements 73, d. h. die in den Hohlraum 75 hineinragende Stirnseite des Stempelelements 73, beim Verfüllen innerhalb der ersten Aussparung 41 angeordnet ist. Beispielsweise liegt das Stempelelement 73 mit seinem in den Hohlraum 75 hineinragenden Ende an der Zwischenschicht 16 an. Bevorzugt ist die in den Hohlraum 75 hineinragende Stirnseite kleiner dimensioniert als eine laterale Ausdehnung der ersten Aussparung 41, d. h. als eine Ausdehnung der ersten Aussparung 41 in einer parallel zur Haupterstreckungsebene HSE verlaufenden Richtung. Es ist auch denkbar, dass das Stempelelement 73 an seinem in den Hohlraum 75 hineinragenden Ende ein verformbares Element, beispielsweise ein Gummielement, aufweist, das abdichtend in der ersten Aussparung 41 eingebracht ist während des Verfüllens.

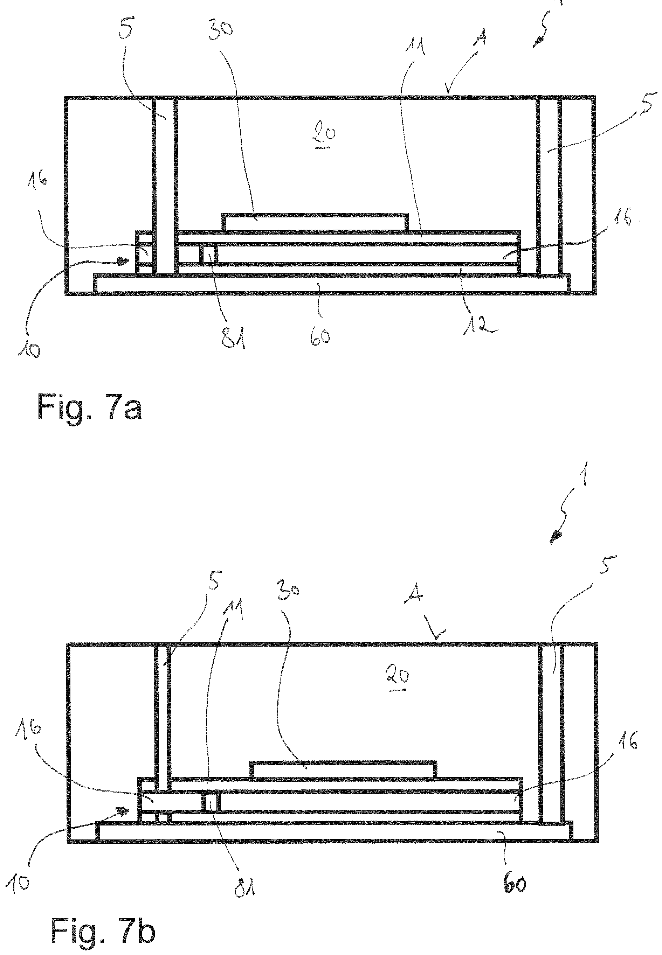

In den **Figuren 7a und 7b** sind Elektromodule 1, hergestellt mit einem erfindungsgemäß Verfahren zur Ausbildung einer vierten beispielhaften Ausführungsform (Figur 7a) und einer fünften beispielhaften Ausführungsform (Figur 7b), dargestellt. Dabei unterscheiden sich die Elektromodule 1 aus den Figuren 7a und 7b von denen aus den vorangegangenen Figuren dahingehend, dass sie eine elektrisch leitende Verbindung zwischen der Außenseite A der Verkapselung 20 und der Kühlstruktur 60 am Trägersubstrat 10 vorsehen. Dabei ist die Kühlstruktur 60 vorzugsweise an der der Außenseite A der Verkapselung 20 gegenüberliegenden Seite des Trägersubstrats 10 ausgebildet und die Kühlstruktur 60 weist beispielsweise Finnen auf oder ist als massives Metallelement bzw. massiver Metallblock ausgebildet. Durch diese elektrische leitende Verbindung ist es in vorteilhafter Weise möglich eine Erdung über die Kühlstruktur 60 an der Außenseite A der Verkapselung 20 bereitzustellen. Dabei kann die elektrisch leitende Verbindung als Durchkontaktierung 5 an dem Trägersubstrat 10 vorbeilaufen, wie es für die Durchkontaktierung 5 in Figur 7a auf der rechten Seite dargestellt ist, oder durch das Trägersubstrat 10 hindurch. Für eine durch das Trägersubstrat 10 durchlaufende Durchkontaktierung 5 ist es vorzugsweise vorgesehen, dass die Zwischenschicht 16 derart strukturiert ist, bzw. vorstrukturiert wurde, dass kein Kurschluss verursacht wird. Beispielsweise sind hierzu Abschnitte der Zwischenschicht 16 durch mindestens einen Freiraum 81 voneinander getrennt. Die auf der linken Seite des Elektromoduls 1 aus Figur 7a dargestellte Durchkontaktierung 5 ist dabei derart ausgebildet, dass sie durch die Primärschicht 11, die Zwischenschicht 16 und die Sekundärschicht 12 hindurchgreift. Bei einer entsprechend tiefen Aussparungen, die für die Bildung der Durchkontaktierung 5 zu füllen wäre, ist mit Vorteil das Verfahren beschrieben in den Figuren 5 und 6 zu verwenden statt einer Bildung mittels Laserlichts, da die Laserbohrung insbesondere für derartig lange Aussparung ungeeignet ist. Weiterhin ist es vorgesehen, dass die erste Metallisierungsschicht 15 entsprechend strukturiert ist, dass kein Kurschluss durch die durch das Trägersubstrat 10 hindurchgreifende Durchkontaktierung 5 realisiert wird.

In der Figur 7b ist es vorgesehen, dass sich die Durchkontaktierung 5 bis zu dem durch den Freiraum 81 abgegrenzten Teil der Zwischenschicht 16 erstreckt und zur Ausbildung der elektrisch leitenden Verbindung eine bodenseitige Durchkontaktierung 5" in der Sekundärschicht 12 realisiert wird. Ein derartiges beidseitiges Realisieren der Durchkontaktierung 5 einerseits und der bodenseitigen Durchkontaktierung 5" andererseits erweist sich beispielsweise in vorteilhafter Weise vereinfachend für das Verfüllen der entsprechend zu verfüllenden Aussparungen aus. Insbesondere stellt die Ausführungsform aus Figur 7b einen besonders vorteilhaften thermischen Pfad bereit.

### Bezugszeichenliste:

- 1: Elektronikmodul
- 5: Durchkontaktierung
- 5': weitere Durchkontaktierung
- 5": bodenseitige Durchkontaktierung
- 7: trägersubstrateigene Durchkontaktierung
- 10: Trägersubstrat
- 11: Primärschicht
- 12: Sekundärschicht
- 15: erste Metallisierungsschicht
- 16: Zwischenschicht
- 20: Verkapselung
- 25: Bauteilseite
- 30: erstes elektronisches Bauteil
- 31: zweites elektronisches Bauteil
- 35: zweite Metallisierungsschicht
- 41: erste Aussparung
- 42: zweite Aussparung
- 43: dritte Aussparung
- 44: vierte Aussparung
- 50: Vorverbund
- 51: Leiterplatte
- 52: Matrix
- 53: Aussparung
- 54: bauteilseitige Anschlüsse
- 55: verbundseitige Anschlüsse
- 60: Kühlstruktur
- 61: Dichtelement
- 71: erste Werkzeughälfte
- 72: zweite Werkzeughälfte
- 73: Stempelelement
- 75: Hohlraum
- 81: Freiraum
- 101: Bereitstellen eines Trägersubstrats
- 102: Verkapseln
- 103: Ausbilden einer Durchkontaktierung
- 104: Ausbilden einer strukturierten zweiten Metallisierungsschicht
- 105: Oberflächenmodifikation
- A: Außenseite
- L: Länge
- S: Stapelrichtung
- HSE: Haupterstreckungsebene

## Patentansprüche

1. Verfahren zur Herstellung eines Elektronikmoduls (1), umfassend:
- Bereitstellen (101) eines mit einem ersten elektronischen Bauteil (30) bestückten Trägersubstrats (10), wobei das Trägersubstrat (10) eine Primärschicht (11), eine Sekundärschicht (12) und eine zwischen der Primärschicht (11) und der Sekundärschicht (12) angeordnete metallische Zwischenschicht (16) aufweist, wobei unter Ausbildung einer Sandwichstruktur die metallische Zwischenschicht (16) die Primärschicht (11) von der Sekundärschicht (12) beabstandet, wobei die Primärschicht (11) zumindest eine erste Aussparung (41) aufweist,
- zumindest teilweise Verkapseln (102) des bestückten Trägersubstrats (10) mit einer Verkapselung (20),
- Realisieren einer zweiten Aussparung (42) in der Verkapselung (20) und
- Ausbilden (103) einer Durchkontaktierung (5) zum Bereitstellen einer elektrischen Verbindung zwischen einem zweiten elektronischen Bauteil (31) an einer Außenseite (A) der Verkapselung (20) und der metallischen Zwischenschicht (16), wobei die erste Aussparung (41) in der Primärschicht (11) und die zweite Aussparung (42) in der Verkapselung (20) in einem Arbeitsschritt mit einem elektrisch leitfähigen Material gemeinsam gefüllt werden,
wobei sich die zwischen der Primärschicht (11) und der Sekundärschicht (12) angeordnete metallische Zwischenschicht (16) in einer parallel zur Haupterstreckungsebene (HSE) verlaufenden Ebene über eine erste Fläche erstreckt und die Primärschicht (11) und/oder die zweite Sekundärschicht (12) über eine zweite Fläche, wobei ein Verhältnis der ersten Fläche zu der zweiten Fläche größer ist als 0,5, bevorzugt größer als 0,75 und besonders bevorzugt größer 0,9.

2. Verfahren gemäß Anspruch 1, wobei die Primärschicht (11), die Zwischenschicht (16) und die Sekundärschicht (12) in einer Stapelrichtung (S) übereinander angeordnet sind und die erste Aussparung (41) und die zweite Aussparung (42) in Stapelrichtung (S) gesehen übereinander jedenfalls teilweise fluchtend angeordnet sind.

3. Verfahren gemäß einem der vorhergehenden Ansprüche, wobei die zweite Aussparung (42) zeitlich nach der Verkapselung (20) und/oder die erste Aussparung (41) zeitlich vor der Verkapselung (20) realisiert wird.

4. Verfahren gemäß einem der vorhergehenden Ansprüche, wobei die zweite Aussparung (42) während des Verkapselns (102) realisiert wird, insbesondere unter Verwendung einer ersten Werkzeughälfte (71) und einer zweiten Werkzeughälfte (72), wobei die erste Werkzeughälfte (71) und die zweite Werkzeughälfte (72) in einem geschlossenen Zustand einen Hohlraum (75) ausbilden, der das Trägersubstrat (10) zumindest teilweise umgibt, wobei die zweite Aussparung (42) beim Verfüllen durch ein Freistellen mittels eines innerhalb des Hohlraums (75) angeordneten Teils eines Stempelelements (73), realisiert wird.

5. Verfahren gemäß einem der vorhergehenden Ansprüche, wobei das Trägersubstrat (10) eine erste Metallisierungsschicht (15) aufweist, an der mindestens ein erstes elektronisches Bauteil (30) angeordnet ist, wobei eine dritte Aussparung (43) in der Verkapselung (20) realisiert wird und wobei die dritte Aussparung (43) mit einem elektrisch leitenden Material gefüllt wird, insbesondere zeitgleich zum Füllen der ersten Aussparung (41) und zweiten Aussparung (42), zur Ausbildung einer weiteren Durchkontaktierung (5'), die eine zweite Metallisierungsschicht (35) an der Außenseite (A) der Verkapselung (20) mit der ersten Metallisierungsschicht (15) und/oder dem ersten elektronischen Bauteil (30) elektrisch verbindet.

6. Verfahren gemäß Anspruch 5, wobei die erste Metallisierungsschicht (15) eine vierte Aussparung (44) aufweist, wobei zum Ausbilden (103) der Durchkontaktierung (5) zum Bereitstellen einer elektrischen Verbindung zwischen einem zweiten elektronischen Bauteil (31) an einer Außenseite (A) der Verkapselung (20) und der metallischen Zwischenschicht (16) die erste Aussparung (41) in der Primärschicht (11), die zweite Aussparung (42) in der Verkapselung (20) und die vierte Aussparung (44) in der ersten Metallisierungsschicht (15) in einem Arbeitsschritt mit einem elektrisch leitfähigen Material gemeinsam gefüllt werden.

7. Verfahren gemäß einem der vorhergehenden Ansprüche, wobei sich die Durchkontaktierung (5) bis zu einer Kühlstruktur (60) am Trägersubstrat (10) erstreckt.

8. Verfahren gemäß einem der vorhergehenden Ansprüche, wobei die Zwischenschicht (16)
- dicker als die Primärschicht (11) und/oder die Sekundärschicht (12) ist und/oder
- dicker als 1 mm, bevorzugt dicker als 1,5 und besonders bevorzugt dicker als 2,5 mm ist.

9. Verfahren gemäß einem der vorhergehenden Ansprüche, wobei die Verkapselung (20) mittels eines Spritgussverfahrens und/oder Spritzpressverfahrens geformt wird, insbesondere um das bestückte Trägersubstrat (10) herum geformt wird.

10. Verfahren gemäß einem der vorhergehenden Ansprüche, wobei die Primärschicht (11) eine Keramikschicht ist.

11. Verfahren gemäß einem der vorhergehenden Ansprüche, wobei die Primärschicht (11) eine in Stapelrichtung (S) bemessene Dicke aufweist, die größer als 100 µm, bevorzugt größer als 200 µm und besonders bevorzugt größer als 250 µm ist.

12. Verfahren gemäß einem der vorhergehenden Ansprüche, wobei ein parallel zur Haupterstreckungsebene (HSE) bemessener Querschnitt der ersten Aussparung (41) größer ist als ein parallel zur Haupterstreckungsebene (HSE) bemessener Querschnitt der zweiten Aussparung (42) ist.

## Claims

1. A method for the production of an electronic module (1), comprising:
- providing (101) a carrier substrate (10) equipped with a first electronic component (30), wherein the carrier substrate (10) has a primary layer (11), a secondary layer (12) and a metallic intermediate layer (16) arranged between the primary layer (11) and the secondary layer (12), wherein in order to form a sandwich structure, the metallic intermediate layer (16) spaces the primary layer (11) from the secondary layer (12), wherein the primary layer (11) has at least one first recess (41),
- at least partially encapsulating (102) the assembled carrier substrate (10) with an encapsulation (20),
- realising a second recess (42) in the encapsulation (20) and
- forming (103) a via (5) for providing an electrical connection between a second electronic component (31) on an outer side (A) of the encapsulation (20) and the metallic intermediate layer (16), wherein the first recess (41) in the primary layer (11) and the second recess (42) in the encapsulation (20) are filled together with an electrically conductive material in a single step, wherein the metallic intermediate layer (16) arranged between the primary layer (11) and the secondary layer (12) extends over a first area in a plane running parallel to the main extension plane (HSE) and the primary layer (11) and/or the second secondary layer (12) extends over a second area, wherein a ratio of the first area to the second area is greater than 0.5, preferably greater than 0.75 and most preferably greater than 0.9.

2. The method according to claim 1, wherein the primary layer (11), the intermediate layer (16) and the secondary layer (12) are arranged on top of one another in a stacking direction (S) and the first recess (41) and the second recess (42) are arranged on top of one another, at least partially aligned, as viewed in stacking direction (S).

3. The method according to any one of the preceding claims, wherein the second recess (42) is realised after the encapsulation (20) and/or the first recess (41) is realised before the encapsulation (20).

4. The method according to any one of the preceding claims, wherein the second recess (42) is realised during the encapsulation (102), in particular with the use of a first tool half (71) and a second tool half (72), wherein the first tool half (71) and the second tool half (72) in an enclosed state form a cavity (75) which at least partially surrounds the carrier substrate (10), wherein the second recess (42) is realised by leaving it free by means of a part of a stamping element (73) arranged within the cavity (75) when filling.

5. The method according to any one of the preceding claims, wherein the carrier substrate (10) has a first metallisation layer (15), on which at least one first electronic component (30) is arranged, wherein a third recess (43) is realised in the encapsulation (20) and wherein the third recess (43) is filled with an electrically conductive material, in particular at the same time as the filling of the first recess (41) and second recess (42), in order to form a further via (5') which electrically joins a second metallisation layer (35) on the outer side (A) of the encapsulation (20) to the first metallisation layer (15) and/or the first electronic component (30).

6. The method according to claim 5, wherein the first metallisation layer (15) has a fourth recess (44), wherein, for forming (103) the via (5) for providing an electrical connection between a second electronic component (31) on an outer side (A) of the encapsulation (20) and the metallic intermediate layer (16), the first recess (41) in the primary layer (11), the second recess (42) in the encapsulation (20) and the fourth recess (44) in the first metallisation layer (15) are filled together with an electrically conductive material in a single step.

7. The method according to any one of the preceding claims, wherein the via (5) extends to a cooling structure (60) on the carrier substrate (10).

8. The method according to any one of the preceding claims, wherein the intermediate layer (16)
- is thicker than the primary layer (11) and/or the secondary layer (12) and/or
- is thicker than 1 mm, more preferably thicker than 1.5 mm and most preferably thicker than 2.5 mm.

9. The method according to any one of the preceding claims, wherein the encapsulation (20) is formed by means of an injection moulding process and/or transfer moulding process, in particular formed around the equipped carrier substrate (10).

10. The method according to any one of the preceding claims, wherein the primary layer (11) is a ceramic layer.

11. The method according to any one of the preceding claims, wherein the primary layer (11) has a thickness, measured in stacking direction (S), which is greater than 100 µm, more preferably greater than 200 µm and most preferably greater than 250 µm.

12. The method according to any one of the preceding claims, wherein a cross-section of the first recess (41), measured parallel to the main extension plane (HSE), is larger than a cross-section of the second recess (42), measured parallel to the main extension plane (HSE).

## Revendications

1. Procédé de fabrication d'un module électronique (1), consistant à:
- fournir (101) un substrat de support (10) équipé d'un premier composant électronique (30), le substrat de support (10) présentant une couche primaire (11), une couche secondaire (12) et une couche intermédiaire métallique (16) disposée entre la couche primaire (11) et la couche secondaire (12), la couche intermédiaire métallique (16) définissant un espacement entre la couche primaire (11) et la couche secondaire (12) en formant une structure en sandwich, la couche primaire (11) présentant au moins un premier évidement (41),
- encapsuler (102) au moins partiellement le substrat de support équipé (10) par une encapsulation (20),
- réaliser un deuxième évidement (42) dans l'encapsulation (20), et
- former (103) un contact traversant (5) pour fournir une connexion électrique entre un deuxième composant électronique (31), situé sur une face extérieure (A) de l'encapsulation (20), et la couche intermédiaire métallique (16), le premier évidement (41) dans la couche primaire (16) et le deuxième évidement (42) dans l'encapsulation (20) étant remplis conjointement, en une seule opération, d'un matériau électriquement conducteur,
dans lequel
la couche intermédiaire métallique (16), disposée entre la couche primaire (11) et la couche secondaire (12), s'étend sur une première surface dans un plan parallèle au plan d'extension principal (HSE), et la couche primaire (11) et/ou la deuxième couche secondaire (12) s'étend sur une deuxième surface, un rapport de la première surface sur la deuxième surface étant supérieur à 0,5, de préférence supérieur à 0,75, et de manière particulièrement préférée supérieur à 0,9.

2. Procédé selon la revendication 1,
dans lequel la couche primaire (11), la couche intermédiaire (16) et la couche secondaire (12) sont superposées dans une direction d'empilement (S), et le premier évidement (41) et le deuxième évidement (42), vus dans la direction d'empilement (S), sont superposés en étant disposés, au moins en partie, en alignement.

3. Procédé selon l'une des revendications précédentes,
dans lequel le deuxième évidement (42) est réalisé après l'encapsulation (20) et/ou le premier évidement (41) est réalisé avant l'encapsulation (20).

4. Procédé selon l'une des revendications précédentes,
dans lequel le deuxième évidement (42) est réalisé pendant l'encapsulage (102), en particulier en utilisant un premier demi-moule (71) et un deuxième demi-moule (72), le premier demi-moule (71) et le deuxième demi-moule (72) formant, dans un état fermé, une cavité (75) qui entoure au moins partiellement le substrat de support (10), le deuxième évidement (42) étant réalisé lors du remplissage par un dégagement au moyen d'une partie d'un élément de poinçon (73) disposé à l'intérieur de la cavité (75).

5. Procédé selon l'une des revendications précédentes,
dans lequel le substrat de support (10) comprend une première couche de métallisation (15) sur laquelle est disposé au moins un premier composant électronique (30),
un troisième évidement (43) est réalisé dans l'encapsulation (20), et
le troisième évidement (43) est rempli d'un matériau électriquement conducteur, en particulier en même temps que le premier évidement (41) et le deuxième évidement (42), pour former un autre contact traversant (5') qui relie électriquement une deuxième couche de métallisation (35), située sur la face extérieure (A) de l'encapsulation (20), à la première couche de métallisation (15) et/ou au premier composant électronique (30).

6. Procédé selon la revendication 5,
dans lequel la première couche de métallisation (15) présente un quatrième évidement (44),
pour former (103) le contact traversant (5) destiné à assurer une connexion électrique entre un deuxième composant électronique (31), situé sur une face extérieure (A) de l'encapsulation (20), et la couche intermédiaire métallique (16), le premier évidement (41) dans la couche primaire (11), le deuxième évidement (42) dans l'encapsulation (20) et le quatrième évidement (44) dans la première couche de métallisation (15) sont remplis conjointement, en une seule opération, d'un matériau électriquement conducteur.

7. Procédé selon l'une des revendications précédentes,
dans lequel le contact traversant (5) s'étend jusqu'à une structure de refroidissement (60) située sur le substrat de support (10).

8. Procédé selon l'une des revendications précédentes,
dans lequel la couche intermédiaire (16)
- est plus épaisse que la couche primaire et/ou la couche secondaire (16), et/ou
- est plus épaisse que 1 mm, de préférence plus épaisse que 1,5 et de manière particulièrement préférée plus épaisse que 2,5 mm.

9. Procédé selon l'une des revendications précédentes,
dans lequel l'encapsulation (20) est moulée par un procédé de moulage par injection et/ou par un procédé de moulage par compression-transfert, en particulier est moulée autour du substrat de support (10) équipé.

10. Procédé selon l'une des revendications précédentes,
dans lequel la couche primaire (11) est une couche céramique.

11. Procédé selon l'une des revendications précédentes,
dans lequel la couche primaire (11) présente une épaisseur mesurée dans la direction d'empilement (S), qui est supérieure à 100 µm, de préférence supérieure à 200 µm, et de manière particulièrement préférée supérieure à 250 µm.

12. Procédé selon l'une des revendications précédentes,
dans lequel une section transversale du premier évidement (41), mesurée parallèlement au plan d'extension principal (HSE), est supérieure à une section transversale du deuxième évidement (42), mesurée parallèlement au plan d'extension principal (HSE).
